# EUROPÄISCHE PATENTSCHRIFT

(11) **EP 4 045 446 B1**
(45) Veröffentlichungstag und Bekanntmachung des Hinweises auf die Patenterteilung: **05.07.2023**
(21) Anmeldenummer: 20799983.0
(22) Anmeldetag: 12.10.2020
(51) Int. Cl.: B65H 23/04, B23K 26/082, B23K 26/08, B65H 23/182, B65H 23/188, B65H 23/195, G03F 7/20, H05K 3/00, B23K 26/00, B23K 26/03, B23K 26/352, B23K 26/70

(54) **VORRICHTUNG ZUR MUSTEREINBRINGUNG MITTELS STRAHLUNG AN EINEM AUFGEWICKELTEN ENDLOSSUBSTRAT**
DEVICE FOR INTRODUCING A PATTERN BY RADIATION ON A WOUND ENDLESS SUBSTRATE
DISPOSITIF POUR RÉALISER DES MOTIFS PAR RAYONNEMENT SUR UN SUBSTRAT SANS FIN ENROULÉ

(30) Priorität: 18.10.2019 DE 102019128198
(43) Veröffentlichungstag der Anmeldung: 24.08.2022
(73) Patentinhaber: Laser Imaging Systems GmbH, 07745 Jena (DE)
(72) Erfinder: VOGT, Peter, 99510 Apolda (DE); STROBEL, Toni, 07745 Jena (DE); PAGEL, René, 07751 Jena (DE); KLOWSKY, Uwe, 07751 Jena (DE); RÜCKER, Steffen, 07751 Großlöbichau (DE); KÖNIG, Christian, 99897 Tambach-Dietharz (DE); WITTER, Marcus, 99425 Weimar (DE)
(74) Vertreter: Gleim Petri Oehmke Patent- und Rechtsanwaltspartnerschaft mbB
(86) Internationale Anmeldenummer: PCT/DE2020/100880
(87) Internationale Veröffentlichungsnummer: WO 2021/073687

(56) Entgegenhaltungen:
- WO-A1-2013/094286
- GB-A- 2 459 154
- JP-A- 2006 098 719
- JP-A- 2007 102 200
- US-A1- 2008 011 225

## Beschreibung

Die Erfindung betrifft eine Vorrichtung zur Mustereinbringung mittels Strahlung an einem aufgewickelten Endlossubstrat, insbesondere zur Belichtung von flexiblen photoempfindlichen Schaltkreisfolien für ein nachfolgendes Ätzen von Leiterbahnen.

Im Stand der Technik für das Herstellen von Leiterbahnen auf flexiblen Trägern sind für die mit hoher räumlicher Präzision auszuführende Belichtung die dafür erforderlichen definierten Handhabungsprozesse von Folien im Millimeter- bis Submillimeterbereich die begrenzenden Faktoren. Dabei kommen z. B. ein- oder beidseitig metallkaschierte Folien mit ein- oder beidseitiger Photoresistlamination oder Folien ohne Metallkaschierung mit ein- oder beidseitiger Photoresistlamination als Folienabschnitte oder als aufgewickelte Endlossubstraten zum Einsatz. Insbesondere ist bei der Bearbeitung von flexiblen Endlossubstraten, die über Walzen oder Rollen transportiert werden, eine definierte Auflage für die Belichtung ausschließlich gekrümmt realisierbar, sodass übliche Maskenbelichtungsverfahren nicht kontinuierlich ausgeführt werden können.

Eine Lösung, die sich dieser Problematik der Maskenbelichtung bei aufgewickelten flexiblen Folien annimmt, ist in der US 2012/0241419 A1 beschrieben. Hierbei wird eine zwischen zwei Rollen (Abwickler- und Aufwickerrollen) über weitere Rollen und eine Belichtungstrommel geführte quasi-endlose Folienbahn für die Belichtung eines Maskenmusters abschnittsweise bewegt. Die Folie ist dabei auf der Belichtungstrommel durch Vakuum angesaugt und wird durch die angetriebene Belichtungstrommel synchron zur Bewegung der Belichtungseinheit mitbewegt, um mittels einer Laserlinie das Maskenmuster zeilenweise entlang je einer Mantellinie der Belichtungstrommel auf die Folie zu belichten. Während dieser Bewegung der Folie auf der Belichtungstrommel sind bei festgehaltenen Auf- und Abwicklerrollen zwei alternativ zwangsgeführte Tänzerrollen für die straffe Führung der Folie zu und von der Belichtungstrommel vorgesehen, die beim Einfahren des nächsten Folienbereichs durch die angetriebenen Ab- und Aufwicklerrollen passiv geschaltet werden. Nachteilig an diesem System ist die an sich diskontinuierliche Folienbewegung, die infolge der präzisen Synchronbewegung der Folie mit der Belichtungseinheit und der Vakuumansaugung während der Belichtung einen hohen Durchsatz an gedruckten Schaltungen, so genannten PCBs (engl.: Printed Circuit Boards), verhindert.

In der EP 1 922 588 B1 sind für eine ähnliche Problematik Musterbelichtungsverfahren und - vorrichtung für eine Belichtung bei kontinuierlicher Folienbewegung beschrieben. Dort wird die Photomaske mit einem regelmäßigen Gittermuster ebenfalls in der Nähe der Belichtungstrommel angeordnet, aber starr gehalten und ein Belichtungsstreifen über eine schmale Lücke zur Belichtungstrommel auf die darauf geführte Folie abgebildet, wobei der Belichtungsstreifen mindestens eine Periode des (gleichmäßigen) Belichtungsmusters für die Nahbelichtung ausleuchtet. Eine Vorgehensweise für ein nicht gleichmäßiges oder nicht periodisches Muster auf der Photomaske ist nicht beschrieben.

Ferner ist aus der WO 2010/075158 A1 ein Verfahren zur Herstellung von flexiblen Schaltkreisfolien als digitale Rolle-zu-Rolle-Photolithographie bekannt geworden, bei dem eine Folienbahn von einer ersten bis zu einer zweiten Position zusammen mit einer Fördertrommel bewegt wird und Ausrichtungsmarken der Folienbahn an einer ersten Position der Trommel gemessen werden, um Verzerrungen der Folienbahn anhand der Ausrichtmarken zu berechnen und eine Belichtung vorzunehmen, wenn die Folienbahn von der ersten zur zweiten Position transportiert worden ist. Dabei erfolgt die Belichtung mit einem Belichtungsmuster, das für eine gegebenenfalls berechnete Verzerrung der Folienbahn entsprechend der ermittelten Lage der Ausrichtmarken korrigiert ist. Wie dabei eine gleichmäßige schlupffreie und verzerrungsarme Bewegung der Folienbahn erfolgt, ist jedoch nicht offenbart.

Ein zusätzliches Problem entsteht bei der Registrierung und Führung einer Folienbahn, wenn die Folie über Targets verfügt, die als Perforationen in den betreffenden Bereichen des Endlossubstrats eingebracht sind. Für deren Registrierung ist eine Auflichtdetektion durch kameragebundene Lichtquellen erschwert, weshalb eine Durchlichtdetektion zu bevorzugen wäre. Für eine solche Registrierung müsste dann entweder die Bearbeitungstrommel selbst leuchten oder die Beleuchtung an einer "fliegend geführten" Folienbahn erfolgen, noch bevor diese in Kontakt mit der Bearbeitungstrommel tritt, womit sich besonders hohe Ansprüche hinsichtlich einer spannungsarmen und lastwechselfreien Führung des Endlossubstrats ergeben. Dokument GB 2 459 154 A offenbart eine Vorrichtung zur Mustereinbringung mittels Strahlung an einem aufgewickelten Endlossubstrat gemäß dem Oberbegriff des Anspruchs 1.

Der Erfindung liegt die Aufgabe zugrunde, eine neue Möglichkeit zur Mustereinbringung mittels Strahlung an einem aufgewickelten Endlossubstrat zu finden, die eine hohe Präzision der Mustereinbringung bei kontinuierlich fortschreitender Rolle-zu-Rolle-Bewegung ohne Materialschlupf und mit minimaler Materialzerrung gestattet. Als erweiterte Aufgabe soll eine problemlose Anpassung an unterschiedliche Materialdicken und -breiten sowie eine einfache und zuverlässige Justierung der Bearbeitungstrommel und Zielmarkenerfassung möglich sein, ohne dass dafür erhebliche Stillstandzeiten benötigt werden. Außerdem soll eine Durchlicht-Registrierung von im Endlossubstrat vorhandenen perforierten Zielmarken möglich sein und eine bereichsweise Links-Rechts-Verzerrung der Substratbahn erkannt und bei der Bearbeitung bzw. Bestrahlung ausgeglichen werden.

Erfindungsgemäß wird die Aufgabe bei einer Vorrichtung zur Mustereinbringung mittels Strahlung an einem aufgewickelten Endlossubstrat, bei der das Endlossubstrat von einer Abwicklerrolle über eine Bearbeitungstrommel auf eine Aufwicklerrolle rollbar geführt ist, wobei eine Registriereinheit zur optischen Aufnahme von Zielmarken und eine Strahlungsquelle zum Einstrahlen eines Strahlungsmusters in zwei unterschiedlichen Richtungen auf die Bearbeitungstrommel gerichtet sind, und eine Steuerungseinheit zur Steuerung der Ausrichtung zwischen Strahlungsmuster und Endlossubstrat und zur örtlichen Differenzierung des Strahlungsmusters vorhanden sind, wobei in der Steuerungseinheit Mittel zur elektronischen Anpassung des Strahlungsmusters an von der Registriereinheit aufgrund der Zielmarken ermittelte Lageabweichungen des Endlossubstrats vorhanden sind, dadurch gelöst, dass zwischen der Bearbeitungstrommel und Abwicklerrolle und Bearbeitungstrommel und Aufwicklerrolle jeweils eine Tänzerrolle zur straffen Führung des Endlossubstrats entlang eines definierten Kontaktbereichs von wenigstens einem halben Umfang der Bearbeitungstrommel vorhanden ist, um mittels eines Antriebs der Bearbeitungstrommel eine Förderbewegung von der Bearbeitungstrommel über den definierten Kontaktbereich schlupffrei auf das Endlossubstrat zu übertragen, dass die Tänzerrollen zu einer gestrafften Führung einer hinlaufenden und einer rücklaufenden Substratbahn des Endlossubstrats mit einer konstanten Kraftwirkung im Gegenzug zum Kontaktbereich an der Bearbeitungstrommel eingerichtet sind, wobei Stabilisierungseinrichtungen zur Einstellung eines Gleichgewichts zwischen einer definierten Gegenkraft und der konstanten Kraftwirkung auf die Tänzerrolle vorhanden und mit einer Messeinheit zur Aufnahme von Änderungen der Auslenkung der jeweiligen Tänzerrolle verknüpft ist, und dass die Abwicklerrolle und die Aufwicklerrolle regelbare Antriebe aufweisen, die in ihrer Drehgeschwindigkeit geregelt sind auf Basis von durch die Messeinheit erfassten Störungen des Kräftegleichgewichts an der Tänzerrolle.

Vorteilhaft weist die Stabilisierungseinrichtung eine Hebeleinrichtung auf, an der die Tänzerrolle zum Ausführen einer Schwenkbewegung angelenkt ist, und enthält einen pneumatisch oder hydraulisch druckgesteuerten Zylinder, der an der Hebeleinrichtung angelenkt ist, um das Gleichgewicht zwischen der definierten Gegenkraft und der konstanten Kraftwirkung auf die Tänzerrolle zu halten, wobei die Hebeleinrichtung eine Auslenkung der Tänzerrolle entlang eines Kreisbogens ermöglicht.

Die Messeinheit zur Aufnahme von Änderungen der Auslenkung der Tänzerrolle ist vorzugsweise als inkrementaler Winkelgeber zur Messung von Winkeländerungen in einer Schwenkachse der Hebeleinrichtung ausgebildet.

In einer weiteren zweckmäßigen Ausführung ist die Messeinheit als inkrementaler Wegsensor zur Messung von linearen Wegänderungen der Schubstange des druckgesteuerten Zylinders ausgebildet.

Des Weiteren kann die Messeinheit zur Aufnahme von Änderungen der Auslenkung der Tänzerrolle vorteilhaft als optischer Winkelgeber so ausgebildet sein, dass mittels eines Lichtstrahls, der über einen Umlenkspiegel an einem Hebelarm der Hebeleinrichtung auf einen Zeilensensor trifft, Winkeländerungen der Hebeleinrichtung als Ortsänderungen des Lichtstrahls am Zeilensensor erfassbar sind.

Die Messeinheit kann außerdem bevorzugt als Dehnungsmessstreifen zur Messung der Durchbiegung an einem Hebelarm der Hebeleinrichtung ausgebildet sein.

Die Stabilisierungseinrichtungen für die Lage der jeweiligen Tänzerrolle sind vorzugsweise an eine Reglereinheit mit einer Regelschleife zwischen der Messeinheit und einem Drehgeschwindigkeitsregler der Abwicklerrolle bzw. der Aufwicklerrolle gekoppelt.

Neben den Tänzerrollen sind zweckmäßig in einer Substratführungseinheit Umlenkrollen vorhanden, die zur beliebigen Änderung der Ab- oder Aufwickelrichtung der Abwicklerrolle bzw. der Aufwicklerrolle vorgesehen.

Es erweist sich ferner als besonders vorteilhaft, wenn in einer Substratführungseinheit neben den Tänzerrollen Umlenkrollen vorhanden sind, die zur Führung des Endlossubstrats derart vorgesehen sind, dass die zur Bearbeitungstrommel hinlaufende Substratbahn und die rücklaufende Substratbahn von und zu räumlich übereinander angeordneten Abwickler- und Aufwicklerrollen geführt sind.

Vorteilhaft sind in einer Strahlbearbeitungseinrichtung die Strahlungsquelle mit einem linienförmigen Bearbeitungsstrahl und die Registriereinheit mit einem streifenförmigen Abtastbereich parallel zu einer Drehachse der Bearbeitungstrommel angeordnet und in unterschiedlichen Axialebenen auf je eine Mantellinie der Bearbeitungstrommel gerichtet.

In einer weiteren zweckmäßigen Strahlbearbeitungseinrichtung sind die Strahlungsquelle mit dem linienförmigen Bearbeitungsstrahl und die Registriereinheit mit dem streifenförmigen Abtastbereich parallel zu der Drehachse der Bearbeitungstrommel angeordnet und in ein und derselben Axialebene auf diametral gegenüber liegende Seiten der Bearbeitungstrommel gerichtet.

Ferner sind in einer weiteren vorteilhaften Strahlbearbeitungseinrichtung die Strahlungsquelle mit einem linienförmigen Bearbeitungsstrahl parallel zu einer Drehachse und in einer Axialebene der Bearbeitungstrommel und die Registriereinheit mit einem streifenförmigen Abtastbereich in einer zu der Axialebene parallelen Registrierebene auf gegenüberliegende Seiten der Bearbeitungstrommel gerichtet, wobei die Registrierebene entgegen der hinlaufenden Substratbahn so weit vorgelagert ist, dass ein Luftspalt zur Einstrahlung einer Rückseitenbeleuchtung vor einem Beginn des Kontaktbereichs des Endlossubstrats mit der Bearbeitungstrommel vorhanden ist.

Vorzugsweise ist die Bearbeitungstrommel auf einem beweglichen Schlitten derart angebracht, dass der Bearbeitungsstrahl der Strahlungsquelle und der streifenförmige Abtastbereich der Registriereinheit durch die Bewegung des Schlittens tangential auf jeweils eine weiter entfernte Mantellinie der Bearbeitungstrommel verschiebbar sind, wodurch die Fokussierungen des Bearbeitungsstrahls sowie der Registriereinheit gegenüber dem auf der Bearbeitungstrommel befindlichen Endlossubstrat einstellbar sind.

Die Bearbeitungstrommel ist bevorzugt auf dem Schlitten derart verschiebbar, dass sie aus der Axialebene der Strahlungsquelle und Registrierebene der Registriereinheit herausfahrbar ist, um auf dem Schlitten zusätzlich angebrachte Justiermittel in Positionen anstelle von Mantellinien der Bearbeitungstrommel in der Registrierebene und der Axialebene zu positionieren.

Eine weitere vorteilhafte Ausführung besteht darin, dass die Bearbeitungstrommel in beiden Randbereichen primäre Kalibriermarken und sekundäre Kalibriermarken aufweist, von denen mindestens die sekundären Kalibriermarken transient durch den Bearbeitungsstrahl erzeugbar sind und die zur Kalibrierung der räumlichen Beziehung zwischen den Koordinatensystemen von Registriereinheit und Strahlungsquelle vorgesehen sind.

Dabei sind die Randbereiche der Bearbeitungstrommel mit einer Photochrombeschichtung versehen, die für einen angepassten Wellenlängenbereich des Bearbeitungsstrahls empfindlich ist, um in einer zweckmäßigen Ausführungsvariante die primären Kalibriermarken und die sekundären Kalibriermarken zu erzeugen.

In einer alternativ anwendbaren Ausführung ist die Bearbeitungstrommel in den Randbereichen mit einem Stahlband zur Einbringung der permanent eingebrachten primären Kalibriermarken belegt, wobei das Stahlband eine Photochrombeschichtung aufweist, die für einen angepassten Wellenlängenbereich des Bearbeitungsstrahls empfindlich ist, um die sekundären Kalibriermarken zu erzeugen.

Eine besonders vorteilhafte Ausführung der Erfindung wird dadurch erreicht, dass
- die Strahlungsquelle als linienförmig gescannter Laser ausgebildet ist und der Bearbeitungsstrahl über die Randbereiche der Bearbeitungstrommel hinaus scannbar ist,
- die Registriereinheit mindestens zwei Kameras zur Aufnahme von Zielmarken des Endlossubstrats sowie von primären und sekundären Kalibriermarken im Randbereich der Bearbeitungstrommel aufweist und
- mindestens ein Photodetektor in axialer Richtung neben der Bearbeitungstrommel angeordnet ist, um wiederholt Intensitätsmessungen des Bearbeitungsstrahls vorzunehmen.

In einer dazu modifizierten Variante ist jeder Photodetektor parallel zur Drehachse in Richtung der Bearbeitungstrommel ausgerichtet und je ein Umlenkspiegel zur Reflexion von neben der Bearbeitungstrommel radial einfallendem Licht des Bearbeitungsstrahls zwischen Bearbeitungstrommel und Photodetektor so positioniert, um das radial einfallende Licht des Bearbeitungsstrahls in Richtung des jeweiligen Photodetektors umzulenken.

Vorteilhaft ist an der Bearbeitungstrommel eine Andruckwalze zum Anpressen des Endlossubstrats angebracht. Dabei kann die Andruckwalze in einem Bereich vor der Axialebene des Bearbeitungsstrahls angebracht sein, wobei die Andruckwalze zugleich mit einer Cleaner-Rolle in Kontakt steht, um das Endlossubstrat vor der Strahlbearbeitung zu reinigen.

Des Weiteren ist es zweckmäßig, wenn an der Bearbeitungstrommel eine Andruckwalze angebracht ist, die zugleich mit einem hochauflösenden Encoder ausgestattet ist, um eine real zwischen Registriereinheit und Bearbeitungsstrahl transportierte Länge der Substratoberfläche des Endlossubstrats zu messen.

Die Erfindung basiert auf der Grundüberlegung, dass die kontinuierliche Strahlungsbearbeitung zur Mustereinbringung an flexiblen Endlossubstraten, insbesondere Folien mit photoempfindlichen Beschichtungen, eine besonders gut ausgerichtete und spannungsarme Substratführung von Rolle zu Rolle erfordert. Die dabei im Stand der Technik verwendeten Verfahren mit Vakuumansaugung an der Bearbeitungstrommel und mit Vorspannung der Substratbahn des Endlossubstrats mittels Tänzerrollen vor und hinter der Bearbeitungstrommel, die üblicherweise selbst den Hauptantrieb darstellt, um eine definierte Bearbeitungsgeschwindigkeit vorzugeben, beeinträchtigen die gleichmäßige und unverzerrte Mitführung der Substratbahn an der Mantelfläche der Bearbeitungstrommel. Ursächlich dafür sind die zusätzlich angetriebenen Abwickler- und Aufwicklerrollen, die angepasste Drehgeschwindigkeiten je nach Rollendurchmesser (aufgrund der übereinander gewickelten Lagen) der Substratbahn realisieren müssen, um die Geschwindigkeit der Substratbahn konstant und möglichst zerrungsfrei zu halten, wobei die dabei an den Ab- und Aufwicklerrollen auftretenden Schwankungen durch motor- und/oder schwerkraftgeregelte Tänzerrollen ausgeglichen werden.

Die Erfindung vermeidet die bei den Änderungen der Abwicklungs- und Aufwicklungsgeschwindigkeiten auf die Substratbahn wirkenden ungleichmäßigen Zugkräfte infolge der Wegnachführung der Tänzerrollen dadurch, dass die Tänzerrollen keine gesonderte Ausgleichsbewegung orthogonal zur Fläche der Substratbahn ausführen, sondern am Beginn der Rolle-zu-Rolle-Bearbeitung einmalig mit geringer Kraft für die Substratbahnstraffung eingestellt und danach mit konstanter Kraft gehalten ("eingefroren") werden, wobei geringste Positionsänderungen der jeweiligen Tänzerrolle als Weg- oder Winkeländerungen der Tänzerrollenhalterung inkremental erfasst und zur Regelung der Drehgeschwindigkeiten von Abwickler- bzw. Aufwicklerantrieben verwendet werden. Dazu sind die Achsen der Tänzerrollen vorzugsweise in einer Hebeleinrichtung gehaltert, wodurch sich kleinste Änderungen der Achslagen der Tänzerrollen hochaufgelöst als Winkel- oder Wegänderungen erfassen lassen und zur Regelung der Abwickler- und Aufwicklerrollen verwendet werden können. Da die Tänzerrollen dabei nahezu unbewegt bleiben und keine Spannungswechsel verursachen, können in einem Bereich der hinlaufenden Substratbahn des Endlossubstrats kurz vor dem Kontaktbereich mit der Bearbeitungstrommel auch im Endlossubstrat perforierte Zielmarken mittels Durchlicht-Beleuchtung registriert werden.

Außerdem ist die Bearbeitungstrommel entlang der Substratbewegungsrichtung (quer zur Scanrichtung der Strahlbearbeitung) vorteilhaft mittels einer Schlittenführung verschiebbar, wodurch mit minimaler Achsverschiebung die Fokussierung der Strahlungsquelle und der Registriereinheit an unterschiedliche Substratdicken angepasst werden kann und eine Verschiebung um ca. den Radius der Bearbeitungstrommel ein Überprüfen und Justieren der Einstellungen von Strahlbearbeitung und Registriereinheit zur Zielmarkenerfassung ermöglicht wird.

Darüber hinaus ist durch fest vorgegebene und transiente Kalibriermarkeneinbringung in einem von der Substratbahn freien Randbereich der Bearbeitungstrommel eine Online-Kalibrierung zwischen Bearbeitungstrommel und Strahlbearbeitungseinrichtung während der Rolle-zu-Rolle-Bearbeitung möglich.

Vor allem gestattet die last- und verzerrungsarme Führung der hin- und rücklaufenden Substratbahnen in der Nähe der Bearbeitungstrommel eine Registrierung von perforierten Zielmarken, indem die Registriereinheit bereits vor dem Erreichen des Kontaktbereichs zwischen Bearbeitungstrommel und Endlossubstrat auf die hinlaufende Substratbahn gerichtet ist, wobei die Substratbahn im keilförmig zulaufenden Luftspalt rückseitig beleuchtet wird und somit perforierte Zielmarken im Durchlichtverfahren wesentlich genauer als bei Auflichtbeleuchtung erfasst werden können. Wenn der Kontaktbereich des Endlossubstrats deutlich mehr als 180° der Bearbeitungstrommel umspannt, kann aufgrund der spannungs- und verzerrungsarmen Substratbahnführung auf die übliche Andruckwalze am Ende des Kontaktbereiches verzichtet werden. Sie kann aber auch an einer Position zwischen Registriereinheit und Bearbeitungsstrahl angebracht sein und als wesentliche Zusatzfunktion mit einer Cleaner-Rolle gekoppelt sein, um das Endlossubstrat unmittelbar vor der Strahlbearbeitung nochmals oder erstmals zu reinigen.

Mit der Erfindung wird eine neue Möglichkeit zur Mustereinbringung mittels Strahlung an einem aufgewickelten Endlossubstrat realisiert, die eine hohe Präzision der Mustereinbringung auf einer Substratbahn bei kontinuierlich fortschreitender Rolle-zu-Rolle-Bewegung ohne Materialschlupf und bei geringster Materialzerrung gestattet. Des Weiteren wird eine problemlose Anpassung an unterschiedliche Materialdicken und -breiten sowie eine hochgenaue Bearbeitung von Endlossubstraten mit perforierten Zielmarken und eine einfache und zuverlässige Justierung der Bearbeitungstrommel und der Zielmarkenerfassung erreicht, sodass erheblich geringere Stillstandzeiten für Materialbereitstellung sowie deren Gleichlauf- und Verzerrungskorrektur und die Justage bzw. steuerungstechnische Korrektur von Zielmarkenregistrierung und Strahlbearbeitung benötigt werden.

Die Erfindung soll nachfolgend anhand von Ausführungsbeispielen näher erläutert werden. Die Zeichnungen zeigen:

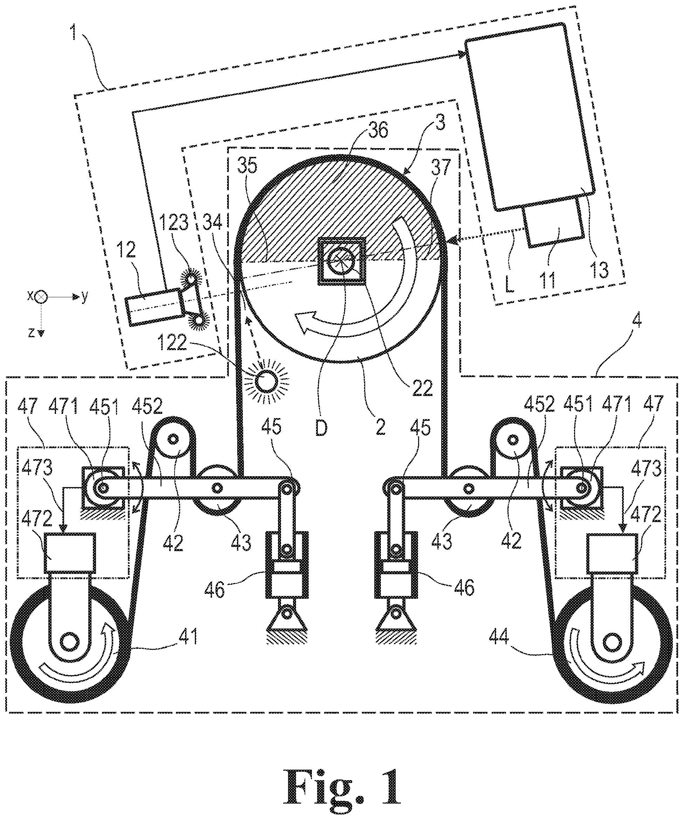

- Fig. 1:: eine schematische Darstellung der erfindungsgemäßen Vorrichtung zur Rolle-zu-Rolle-Bearbeitung von flexiblem Endlossubstrat, die durch mittels druckgesteuerter Zylinder im Gleichgewicht gehaltene Tänzerrollen konstante Kraftwirkungen auf die Substratbahn des Endlossubstrats sichert;

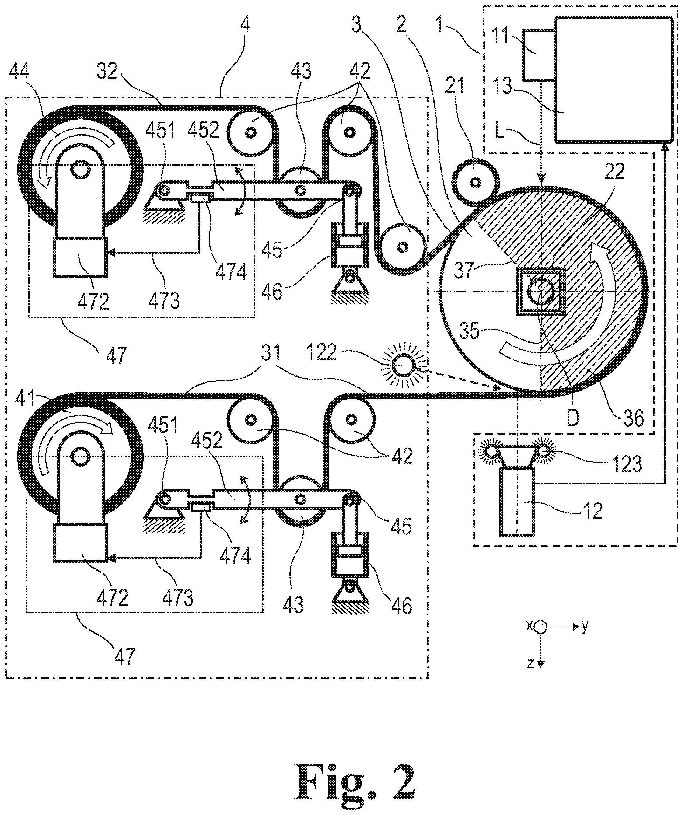

- Fig. 2:: eine vorteilhafte Ausführungsvariante der erfindungsgemäßen Vorrichtung zur Rolle-zu-Rolle-Bearbeitung mit einer Substratbahnführung, bei der Abwickler- und Aufwicklerrollen auf derselben Maschinenseite angeordnet und durch Messung der Durchbiegung eines die Tänzerrolle haltenden Hebelarms geregelt sind;

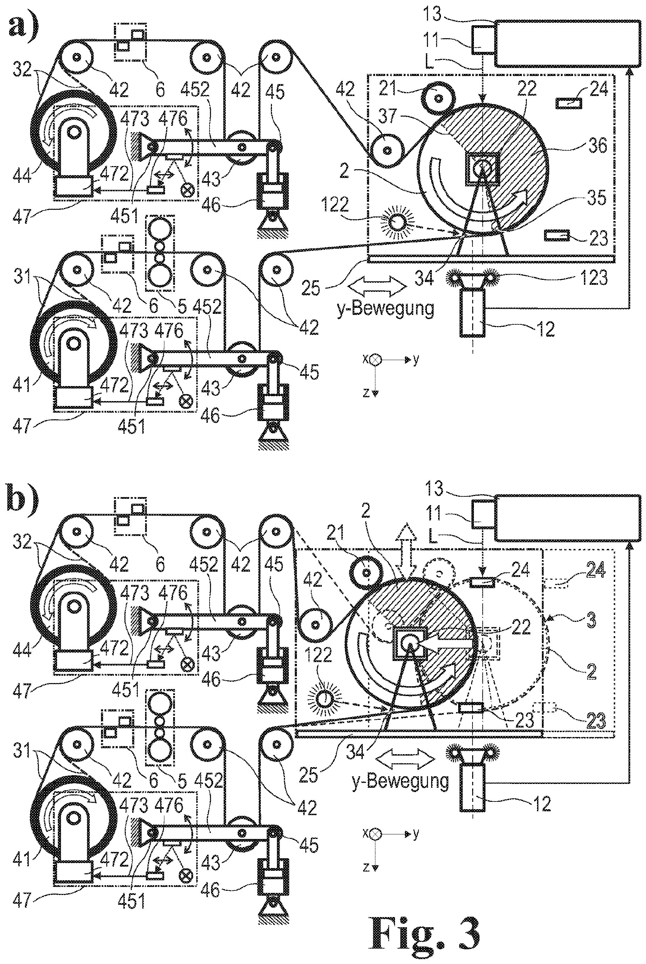

- Fig. 3:: eine weitere bevorzugte Ausführung der erfindungsgemäßen Vorrichtung mit Regelung der Ab- und Aufwicklerrollen auf Basis optisch gemessener Winkeländerungen der die Tänzerrolle tragenden Hebeleinrichtung und mit einer auf einem Schlitten longitudinal zur Richtung der Substratbahnbewegung verschiebbaren Bearbeitungstrommel, die a) im Bearbeitungsprozess und b) in einer Bearbeitungspause zur Justage von Registriereinheit und Bearbeitungsstrahl oder zum einfachen Austausch der Bearbeitungstrommel gezeigt ist;

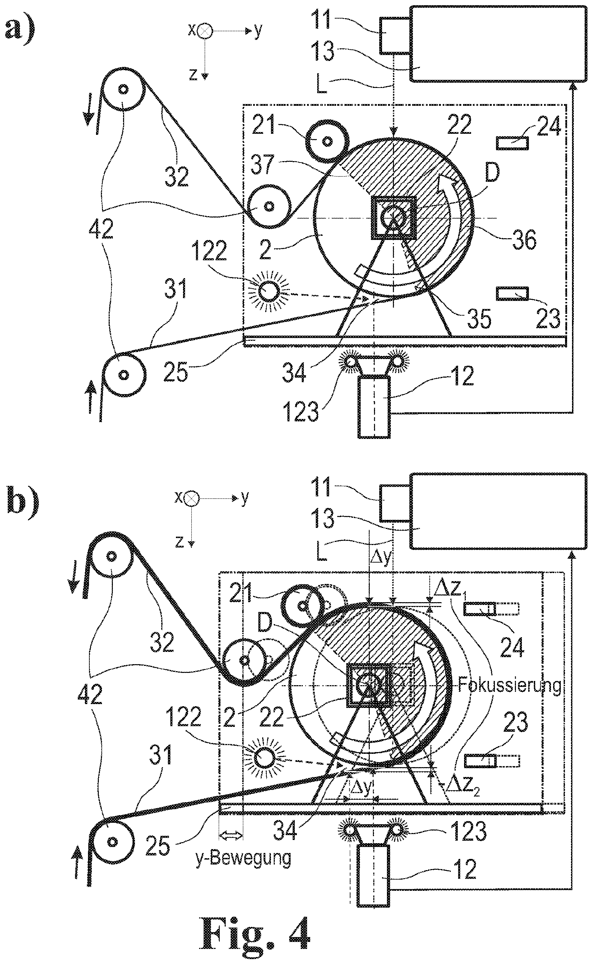

- Fig. 4:: eine weitere bevorzugte Modifikation der erfindungsgemäßen Vorrichtung gemäß Fig. 2 oder Fig. 3 mit einer einfachen Fokussierungsmöglichkeit auf Basis der longitudinal zur Richtung der Substratbahnbewegung verschiebbaren Bearbeitungstrommel, die in Teilabbildungen a) die Einstellung eines minimalen Fokusabstandes und b) die Einstellung eines vergrößerten Fokusabstandes zeigt;

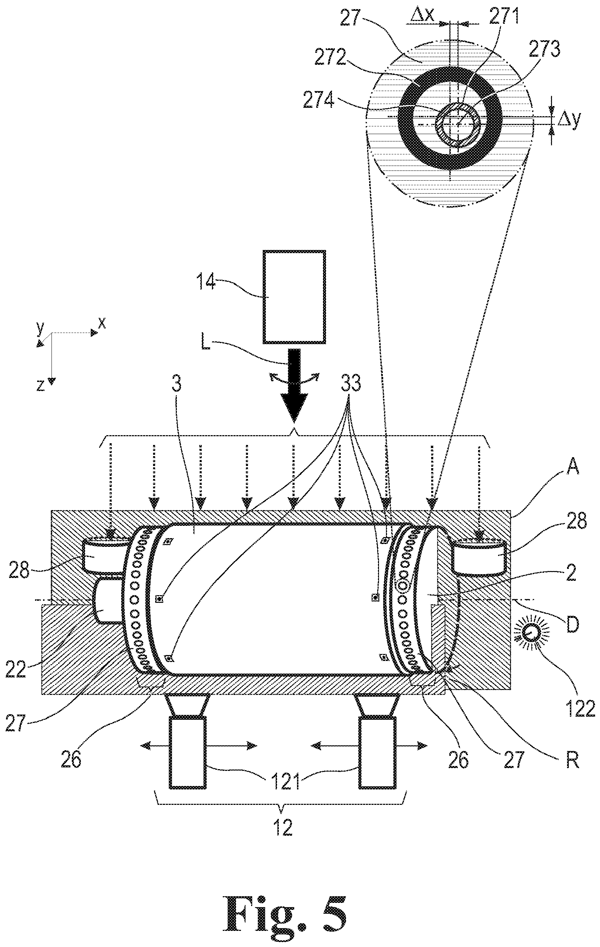

- Fig. 5:: eine vorteilhafte Ausführung der Strahlbearbeitungseinrichtung und der Bearbeitungstrommel in einer Vorrichtung gemäß Fig. 2 oder Fig. 3, bei der zur optischen Registrierung von Zielmarken auf dem Endlossubstrat und für eine Kalibrierung der optischen Strahlbearbeitung bei laufendem Bearbeitungsvorgang zwei bewegliche Kameras in den Randbereichen der Bearbeitungstrommel vorhanden und Photodetektoren zur Strahlungsmessung neben der Bearbeitungstrommel angeordnet sind;

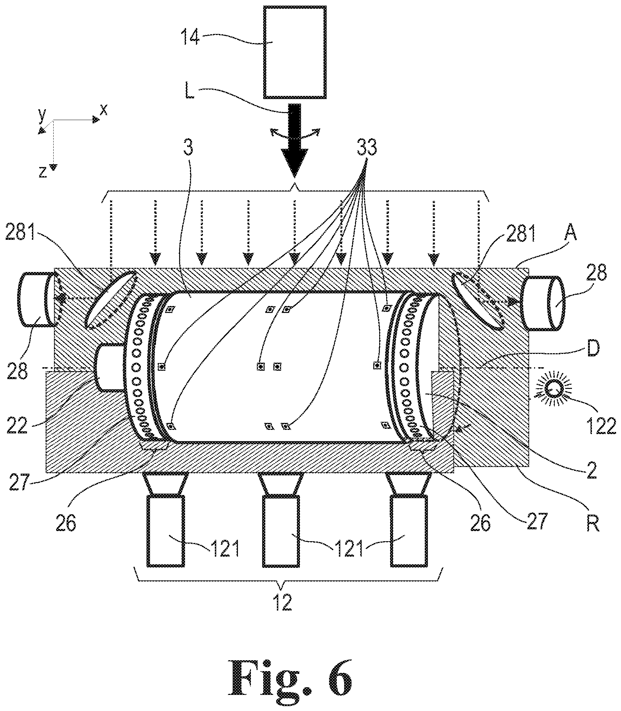

- Fig. 6:: eine gegenüber Fig. 5 modifizierte Ausführung von Strahlbearbeitungseinrichtung und Bearbeitungstrommel, bei der zur optischen Registrierung von Zielmarken auf dem Endlossubstrat und zur Kalibrierung der optischen Strahlbearbeitung bei laufender Bearbeitung drei feste Kameras für die Markenabtastung auf dem Endlossubstrat und der Bearbeitungstrommel vorhanden und zur Strahlungsmessung neben der Bearbeitungstrommel Lichtanteile der Strahlungsquelle über Umlenkspiegel auf Photodetektoren gerichtet sind;

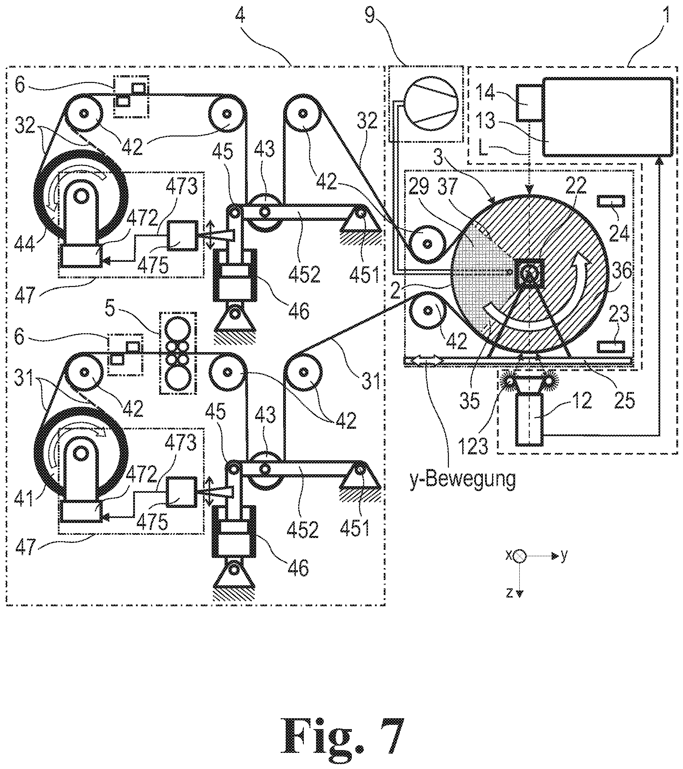

- Fig. 7:: eine Darstellung der erfindungsgemäßen Vorrichtung in einer Ausführung, bei der eine Auflichtbeleuchtung für die Registriereinheit vorhanden ist und die Laufrichtung der Abwickler- und Aufwicklerrollen beliebig - je nach vorhandener Beschichtung/Veredlung der Substratbahn - für auf der Bearbeitungstrommel aufliegende unterschiedliche Seiten der Substratbahn umgeschaltet werden kann und die eine weitere vorteilhafte Ausführung einer Messeinheit zur Störgrößenerfassung für die Geschwindigkeitsregelung der Ab- und Aufwicklerrollen aufweist;

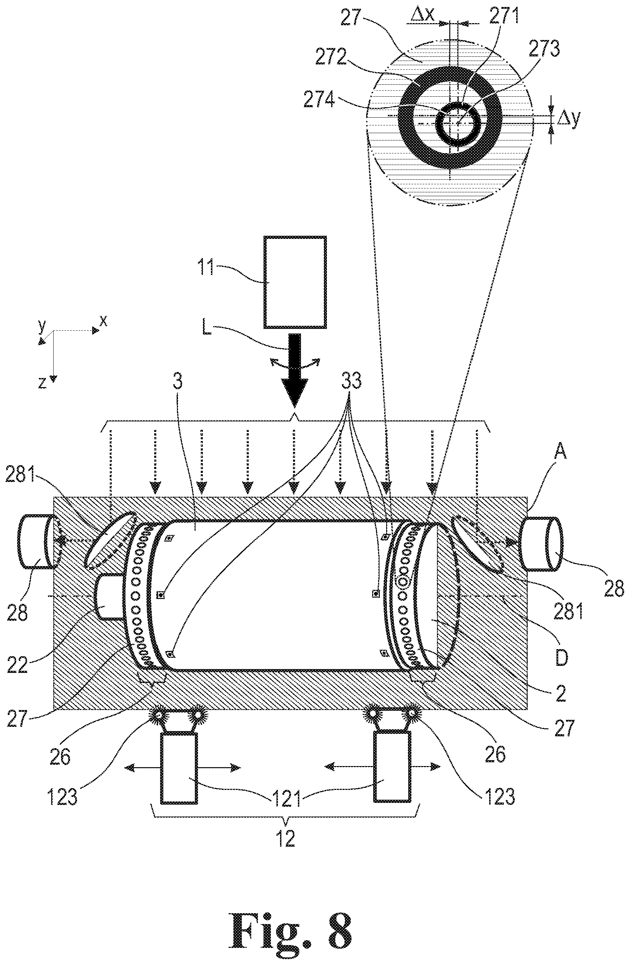

- Fig. 8:: eine vorteilhafte Ausführung der Strahlbearbeitungseinrichtung und der Bearbeitungstrommel in einer Vorrichtung gemäß Fig. 7, bei der zur optischen Registrierung von Zielmarken auf dem Endlossubstrat und für eine Kalibrierung der optischen Strahlbearbeitung bei laufendem Bearbeitungsvorgang zwei bewegliche Kameras für die Randbereiche der Bearbeitungstrommel vorhanden und Photodetektoren zur Strahlungsmessung neben der Bearbeitungstrommel angeordnet sind.

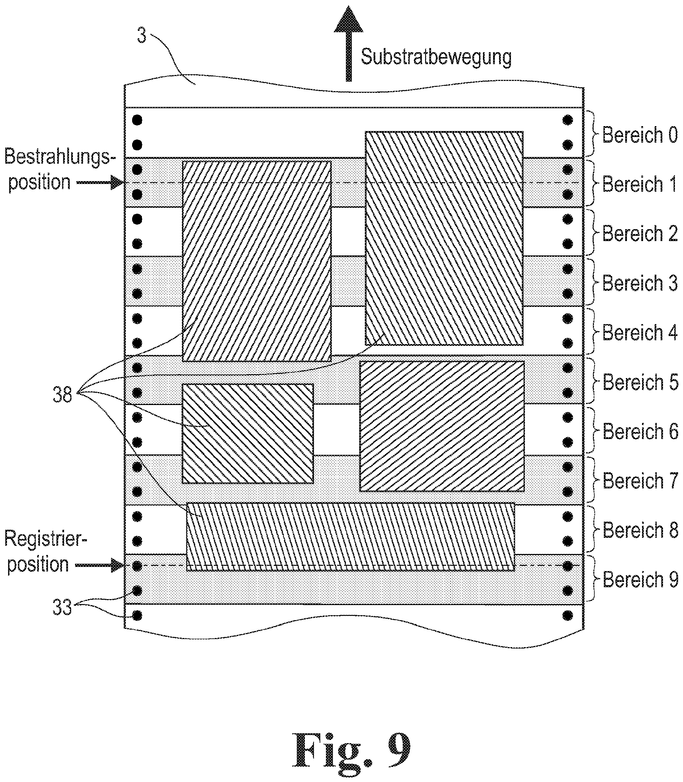

- Fig. 9:: eine weitere vorteilhafte Ausführung der Erfindung, bei der die Registriereinheit einzelne Abschnitte des Endlossubstrats mit wenigstens vier Zielmarken aufeinanderfolgend abtastet und in der Steuerungseinheit die Korrelation des Bestrahlungsmusters zu den Zielmarken auf Basis der erfassten Zielmarkenlage des jeweiligen Abschnitts sowie einer Mittelung der Zielmarken weiterer Abschnitte erfolgt,

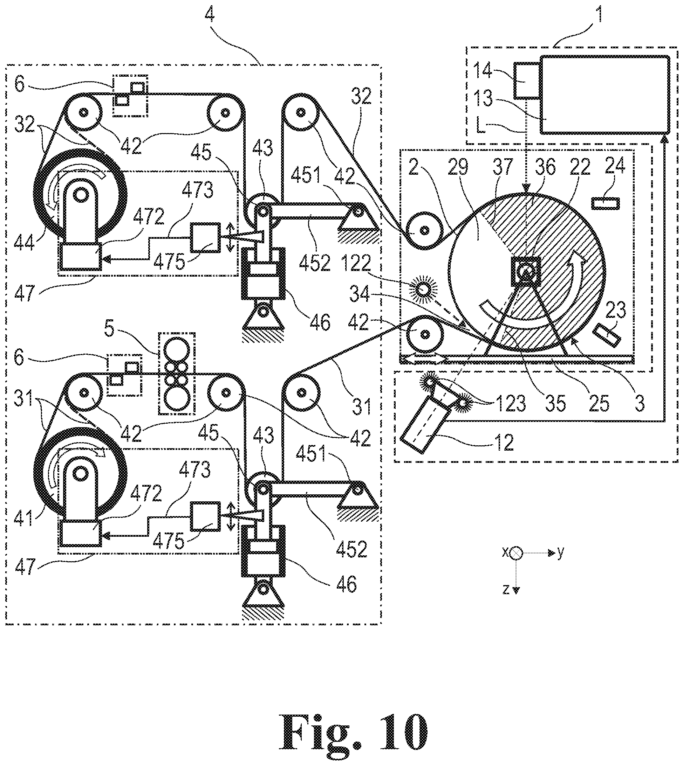

- Fig. 10:: eine weitere vorteilhafte Ausführung der erfindungsgemäßen Vorrichtung, bei der für die Registriereinheit eine Rückseitenbeleuchtung des Endlossubstrats und für die Messeinheit zur Ab- und Aufwicklerregelung ein Wegmesssystem an dem druckgesteuerten Zylinder vorhanden ist,

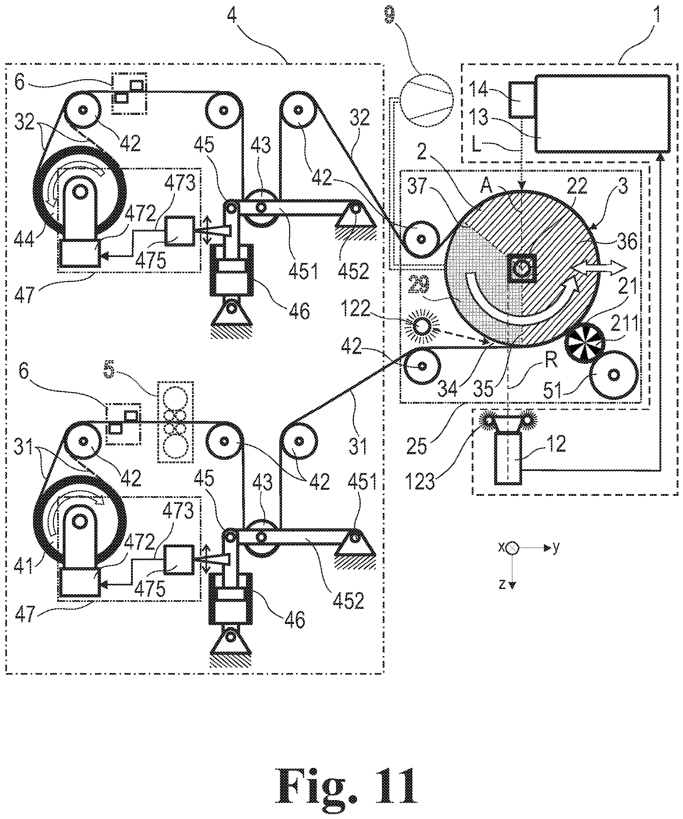

- Fig. 11:: eine vorteilhafte gegenüber Fig. 10 modifizierte Ausführung der Erfindung, bei der die Andruckwalze zwischen Registriereinheit und Bearbeitungsstrahl angeordnet, mit einem hochauflösenden Encoder ausgestattet und mit einer Cleaner-Rolle verknüpft ist,

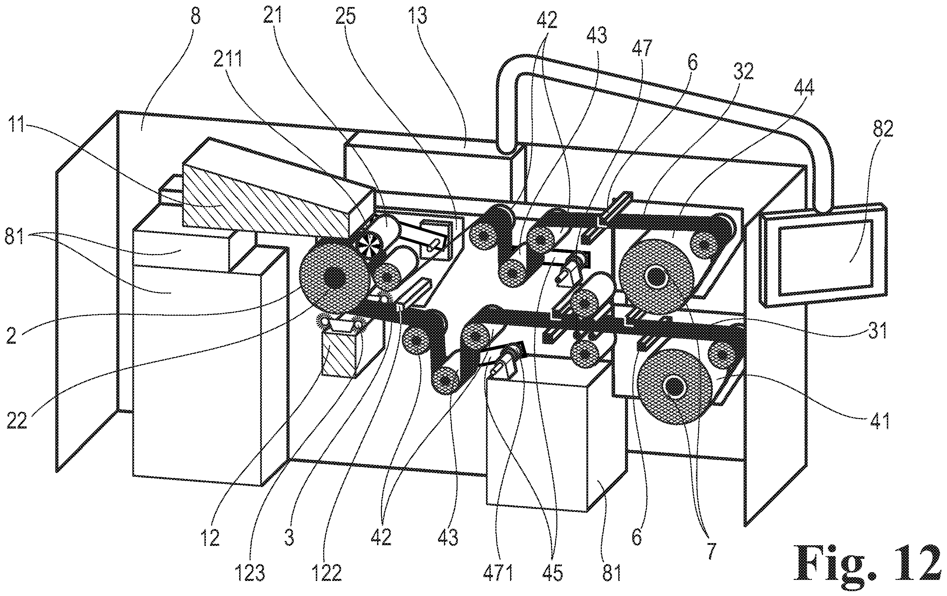

- Fig. 12:: eine perspektivische Darstellung einer vorteilhaften Ausführung der erfindungsgemäßen Vorrichtung innerhalb eines teilweise geöffneten Gehäuses.

Eine Ausführung der erfindungsgemäßen Vorrichtung umfasst in einem Grundaufbau gemäß Fig. 1 eine Strahlbearbeitungseinrichtung 1 mit einer linienförmig gescannten Strahlungsquelle 11, einer Registriereinheit 12 und einer Steuerungseinheit 13, die als wesentlichen Bestandteil eine Musterbereitstellung und die Steuerung von Zielmarkenerfassung der Registriereinheit 12 und Strahlungslinie der Strahlungsquelle 11 zur Mustererzeugung beinhaltet, eine angetriebene Bearbeitungstrommel 2, auf der an mindestens der Hälfte ihres Umfangs ein Endlossubstrat 3 mitgeführt wird, sowie eine Substratführungseinheit 4, in der das Endlossubstrat 3 für das Abrollen an der Bearbeitungstrommel 2 von einer Abwicklerrolle 41 über Umlenkrollen 42 und eine Tänzerrolle 43 zur Bearbeitungstrommel 2 sowie von der Bearbeitungstrommel 2 über Umlenkrollen 42 und eine Tänzerrolle 43 auf eine Aufwicklerrolle 44 geführt ist, wobei die Tänzerrollen 43 jeweils an einer Hebeleinrichtung 45, die von einem druckgesteuerten Zylinder 46 gegen Schwerkraft oder eine andere zur Straffung des Endlossubstrats 3 vorgesehene Kraft im Gleichgewicht gehalten wird, angelenkt sind und jeweils eine Reglereinheit 47 aufweisen, die als Messeinheit einen Messwertgeber zur Erfassung von Auslenkungen der Hebeleinrichtung 45 aus einer Gleichgewichtslage enthält und eine Regelschleife 473 zu einem Drehgeschwindigkeitsregler 472 der Abwicklerrolle 41 bzw. der Aufwicklerrolle 44 aufweist. In der vorliegenden Ausführung ist der Messwertgeber ein inkrementaler Winkelgeber 471 an der gehäusefesten Schwenkachse 451 der Hebeleinrichtung 45.

Die vorstehend beschriebene hochgenaue Bewegung des Endlossubstrats 3 bezogen auf die Scanfrequenz (bzw. den Takt) der Strahlbearbeitungseinrichtung 1 ist für eine Direktbestrahlung des Endlossubstrats 3 durch die Strahlungsquelle 11 eigentlich dringend erforderlich. Die Geschwindigkeitsvorgabe der Strahlbearbeitung erfolgt durch die Bearbeitungstrommel 2, d.h. Letztere sorgt für die Vorschubbewegung des Endlossubstrats 3, das auf wenigstens der Hälfte des Umfangs der Bearbeitungstrommel 2 mitgeführt wird. Damit diese Vorschubbewegung gleichmäßig und gleichförmig erfolgen kann, muss das Endlossubstrat 3 nahezu frei von äußeren Störkräften zugeführt und abgeführt werden.

Des Weiteren ist für die Direktbestrahlung des Endlossubstrats 3 eine definierte Ortszuweisung auf dem Endlossubstrat 3 anhand von darauf befindlichen Zielmarken 33 (sog. Targets) erforderlich. Eine in Fig. 1 gezeigte Variante der Detektion von Zielmarken 33 (erst in Fig. 5 gezeichnet) in den Randbereichen des Endlossubstrats 3 ist für perforierte Zielmarken 33 vorzugsweise in Form von Kreislöchern, Dreiecken, Vierecken, insbesondere Quadraten, oder Lochmustern aus Kombinationen von mehreren der vorgenannten perforierten Formen geeignet. Bei der Registrierung solcher perforierter Zielmarken 33 erweist es sich von besonderem Vorteil, diese in der Registriereinheit 12 unter einer Rückseitenbeleuchtung 122 des Endlossubstrats 3 zu erfassen. Für diesen Zweck ist die Beleuchtung eines Luftspaltes 34 vor dem Beginn 35 des Kontaktbereichs 36 der zur Bearbeitungstrommel 2 hinlaufenden Substratbahn 31 (nur in Fig. 2 bezeichnet) beleuchtet. Alternativ könnte auch die Bearbeitungstrommel 2 eine lumineszierende oder anderweitig selbst leuchtende Oberfläche (nicht dargestellt) aufweisen.

Die Funktion der Reglereinheit 47 besteht darin, die am Endlossubstrat 3 angreifenden Kräfte zwischen der Abwicklerrolle 41, der Bearbeitungstrommel 2 und der Aufwicklerrolle 44 derart zu begrenzen, dass an der Bearbeitungstrommel 2 auf das Endlossubstrat 3 nur möglichst geringe und gleich große Kräfte an Abwicklerseite und Aufwicklerseite wirken, sodass das Endlossubstrat 3 an der Bearbeitungstrommel 2 - gegebenenfalls mit Unterstützung einer Andruckwalze 21 (nur in Fig. 2 gezeichnet) - ohne Schlupf und Verzerrungen mitgeführt werden kann. Die Kräfte an Abwicklerseite und Aufwicklerseite werden dabei wie folgt eingestellt.

Am Beginn des Bearbeitungsvorgangs, d.h. wenn das Endlossubstrat 3 in die Substratführungseinheit 4 von der (vollen) Abwicklerrolle 41 über Umlenkrolle(n) 42, Tänzerrolle 43, Bearbeitungstrommel 2, Tänzerrolle 43 und Umlenkrolle(n) 42 zur (leeren) Aufwicklerrolle 44 eingespannt wurde, wird das Endlossubstrat 3 hauptsächlich durch die Bearbeitungstrommel 2 in Gang gesetzt, wobei Abwicklerrolle 41 und Aufwicklerrolle 44 angepasst dazu angetrieben werden. Gemäß dem Stand der Technik werden die Tänzerrollen 43 dazu eingesetzt, die entstehenden Längendifferenzen beim Abwickeln und Aufwickeln des Endlossubstrats 3 gegenüber der konstanten Antriebsbewegung der Bearbeitungstrommel 2 auszugleichen, indem die an der Achse der Tänzerrolle 43 konstant angreifende Zugkraft eine lineare Ausgleichsbewegung der Tänzerrolle 43 orthogonal zur Fläche der Substratbahn 31, 32 in der Hauptbewegungsrichtung des Endlossubstrats 3 ermöglicht.

Im Gegensatz dazu gibt es in der erfindungsgemäßen Vorrichtung für das von Rolle zu Rolle bewegte Endlossubstrat 3 neben dem mittels Präzisionsencoder geregelten Antrieb 22 der Bearbeitungstrommel 2 zwei unabhängig gekoppelte Regler für die Abwicklerrolle 41 und die Aufwicklerrolle 44. Sobald die Bearbeitungstrommel 2 angetrieben wird, werden auch die Abwickler- und Aufwicklerrollen 41 und 44 entsprechend geregelt angetrieben.

Vor dem Anlagenstart wird zunächst im statischen Zustand, bei dem alle drei Antriebsachsen stehen, an den Tänzerrollen 43 jeweils eine definierte Kraft entsprechend der gewünschten Vorspannung des Endlossubstrats 3 eingestellt, indem eine vorgegebene konstante Zugkraft (z.B. Schwerkraft, Federkraft, magnetische, elektrische Feldkraft oder pneumatische Kraft) durch eine steuerbare Gegenkraft auf einen Gleichgewichtszustand mit definierter Kraftwirkung auf das Endlossubstrat 3 "eingefroren" wird. Da für beide Tänzerrollen 43, sowohl an der hinlaufenden Substratbahn 31 als auch an der rücklaufenden Substratbahn 32, die gleiche Vorspannung eingestellt wird, befindet sich das System aus den Tänzerrollen 43 und dem um die Bearbeitungstrommel 2 gewundenen Endlossubstrat 3 in einem statischen Gleichgewicht. Die Raumlage der orthogonal zu ihrer Achsrichtung in einer Ebene beweglichen Tänzerrollen 43 wird durch ein geeignetes Positionsmesssystem, wie nachfolgend noch genauer beschrieben, erfasst und zur Regelung der Drehzahlen von Abwickler- und Aufwicklerrollen 41 bzw. 44 verwendet.

Für diese Steuerungsfunktion ist die Achse jeder Tänzerrolle 43 an der Hebeleinrichtung 45 angelenkt und in einer ersten Ausführung wird eine auftretende Winkeländerung in der Schwenkachse 451 der Hebeleinrichtung 45 mittels einer Messeineinheit als Störgröße ermittelt und dann in einer Reglereinheit 47 als Stellgröße zur Änderung der Drehgeschwindigkeit der Abwicklerrolle 41 bzw. der Aufwicklerrolle 44 verwendet.

Diese Art der Tänzerrollenführung, bei der nur Minimalauslenkungen zugelassen werden, weil bereits infinitesimal kleine Auslenkungen eine angepasste Regelung der Abwickler- und Aufwicklerrollen 41 bzw. 44 auslösen, vermeidet die durch systembedingte Änderungen der Abwicklungs- und Aufwicklungsgeschwindigkeiten auf die hin- bzw. rücklaufenden Substratbahnen 31 bzw. 32 wirkenden ungleichmäßigen Zugkräfte, die ansonsten infolge der Wegnachführung der Tänzerrollen 43 entstehen würden. Die Tänzerrollen 43 führen gemäß der Erfindung keine gesonderte Ausgleichsbewegung quer zur Hauptbewegungsrichtung des Endlossubstrats 3 aus, sondern werden "eingefroren" mit einer konstanten Kraft gehalten, die am Beginn der Rolle-zu-Rolle-Bearbeitung einmalig als geringe definierte Zugkraft (10 - 150 N, bevorzugt 10 - 40 N) für die Substratbahnstraffung eingestellt wurde. Der am Beginn eingestellte Zustand eines statischen Gleichgewichts wird vorzugsweise mittels druckgesteuerter Zylinder 46 (z.B. Pneumatik- oder Hydraulikzylinder) gehalten und zwecks rückstellender Regelung der Drehgeschwindigkeiten der Abwicklerrolle 41 bzw. der Aufwicklerrolle 44 überwacht.

Wird nun der Transport des Endlossubstrats 3 durch das Ansteuern der drei genannten Transportantriebe, Bearbeitungstrommel 2 als Hauptförderantrieb, Abwicklerrolle 41 und Aufwicklerrolle 44 als angepasst gekoppelte Hilfsantriebe, gestartet, so wird sich bei nicht aufeinander abgestimmten Antrieben von Bearbeitungstrommel 2, Abwicklerrolle 41 und Aufwicklerrolle 44 die Position der Tänzerrolle 43 entsprechend der tatsächlichen Bewegung des Endlossubstrats 3 zu ändern versuchen. Diese Positionsänderungen werden an der Hebeleinrichtung 45, an der die jeweilige Tänzerrolle 43 schwenkbar angelenkt ist, in Winkeländerungen umgewandelt, wodurch eine stabile Führung der Achse der Tänzerrolle 43 erreicht und eine einfache Feineinstellung der Gegenkraft zur vorhandenen Zugkraft an der Tänzerrolle 43 ermöglicht wird.

Im Beispiel gemäß Fig. 1 werden die Positionsänderungen der Tänzerrolle 43 durch einen an der Schwenkachse 451 der Hebeleinrichtung 45 angeordneten inkrementalen Winkelgeber 471 der Reglereinheit 47 als Störgröße erfasst und über eine Regelschleife 473 als Regelgröße einem Drehgeschwindigkeitsregler 472 der Abwicklerrolle 41 bzw. der Aufwicklerrolle 44 zugeführt.

In anderen Ausführungen der Erfindung können die Auslenkungen der Tänzerrollen 43 auch als Wegänderungen an der Hebeleinrichtung 45 (Fig. 7 und Fig. 10) erfasst werden.

Die Wegänderung kann beispielsweise aufgrund der Durchbiegung eines Hebelarms 452 der Hebeleinrichtung 45 mittels Dehnungsmessstreifen 474 (wie in Fig. 2 gezeichnet) erfasst und dann in gleicher Weise in die Regelschleife 473 als Störgröße eingespeist werden.

Eine Wegänderung kann aber auch mittels eines inkrementalen Wegsensors 475 an den Schubstangen der Zylinder 46 gemessen werden (wie in Fig. 7 schematisch gezeigt). Dafür stehen vorzugsweise optische, insbesondere interferenzielle oder abbildende photoelektrische, magnetische oder elektrische Sensoren zur Verfügung.

Außerdem besteht die Möglichkeit der Empfindlichkeitssteigerung der Störgrößenerfassung an der Hebeleinrichtung 45 gemäß der Darstellung der Reglereinheiten 47 in Fig. 3, indem die Störgröße wiederum von der bereits in Fig. 1 verwendeten Winkeländerung der Hebeleinrichtung 45 abgeleitet wird. Die Erfassung der Winkeländerung erfolgt in diesem Beispiel optisch über eine Spiegelverkippung am Hebelarm 452 mittels eines Lichtreflexes. Auf diese Weise können die Winkeländerungen der Hebeleinrichtung 45 jeweils auf den doppelten Winkelbetrag vergrößert und auf einem photoelektrischen Zeilensensor 476 erfasst werden. Diese hochaufgelöste Ortsänderung des Lichtreflexes wird dann als Störgröße in die Regelschleife 473 eingespeist und als Regelgröße für den Drehgeschwindigkeitsregler 472 zur Anpassung der Drehbewegung der Abwickler- oder Aufwicklerrolle 41 bzw. 44 verwendet.

Neben den drei oben genannten Transportantrieben verfügt das Rolle-zu-Rolle-System über quer zur Transportrichtung bewegliche Achsen der Abwicklerrolle 41 und der Aufwicklerrolle 44, um durch Regelung über einen branchenüblichen Bahnkantenregler 6 eine genaue Einhaltung der Transportrichtung für das Rolle-zu-Rolle-System und ein genaues Aufwickeln des bearbeiteten Endlossubstrats 3 zu gewährleisten. In der Ausführung gemäß Fig. 3 ist nach dem Bahnkantenregler 6 in der zur Bearbeitungstrommel 2 hinlaufenden Substratbahn 31 eine Cleaner-Einheit 5 angeordnet, um das Endlossubstrat 3 vor der Bearbeitungstrommel 2 von Staub und anderen Kontaminationen zu befreien.

Ziel der Regelung in der Reglereinheit 47 ist es, die ursprüngliche Lage der Tänzerrollen 43 beizubehalten. Im Ergebnis folgt der Transport des Endlossubstrats 3 an der Abwicklerrolle 41 und der Aufwicklerrolle 44 immer dem durch Präzisionsencoder gesteuerten Antrieb 22 der Bearbeitungstrommel 2, und zwar unabhängig vom aktuellen Wickeldurchmesser von Abwickler- bzw. Aufwicklerrolle 41, 44. Die Tänzerrollen 43 verharren dabei innerhalb der Regelgenauigkeit in ihrer anfänglich eingestellten Position und die eingestellten Vorspannungen der hinlaufenden Substratbahn 31 bzw. der rücklaufenden Substratbahn 32 bleiben konstant.

Damit dieses Prinzip funktioniert, ist eine Mindestreibung zwischen Bearbeitungstrommel 2 und Endlossubstrat 3 erforderlich. Um diese auch bei geringer Substratbahnspannung zu gewährleisten, kommt in der Regel eine Andruckwalze 21 (sog. Nipwalze) mit einstellbarer Andruckkraft zum Einsatz, die das Endlossubstrat 3 nach der Strahlbearbeitungszone an die Bearbeitungstrommel 2 zusätzlich andrückt und zwangsgeführt mitläuft. Die erforderliche Reibungskraft zum schlupffreien Transport des Endlossubstrats 3 entlang der zylindrischen Mantelfläche der Bearbeitungstrommel 2 zwischen Registriereinheit 12 und linear gescannter Strahlungsquelle 11 wird aber hauptsächlich dadurch erzeugt, dass das Endlossubstrat 3 über einen Winkelbereich von mindestens 180° mit der Mantelfläche der Bearbeitungstrommel 2 in Kontakt steht. Wird die Kontaktfläche weiter vergrößert, beispielsweise auf ca. 270°, wie in Fig. 7 dargestellt, kann bei geeigneter Affinität des Endlossubstrats 3 die Andruckwalze 21 auch ganz entfallen. Die Andruckwalze 21 kann auch bei bestimmten Materialien des Endlossubstrats 3 entfallen, wenn diese - z. B. durch materialbedingt hohe Haftreibung oder durch elektrische Aufladung - an der Bearbeitungstrommel 2 eine besonders starke Anhaftungswirkung entfalten.

In Fig. 2 ist eine bevorzugte Ausführung der Erfindung gezeigt, die gegenüber Fig. 1 den Vorteil aufweist, dass eine besonders kompakte und raumsparende Gerätekonfiguration realisiert werden kann. In dieser sehr kompakten Ausführung der Substratführungseinheit 4 sind sowohl die Abwicklerrolle 41 als auch die Aufwicklerrolle 44 übereinander an derselben Geräteseite angebracht, wodurch das Endlossubstrat 3 eine zur Bearbeitungstrommel 2 hinlaufende Substratbahn 31 und eine von der Bearbeitungstrommel 2 rücklaufende Substratbahn 32 aufweist, die beide nahezu parallel geführt sind, und somit ein besonders großer Umfangsbereich der Bearbeitungstrommel 2 mit dem Endlossubstrat 3 in Kontakt steht, der zur großflächigen Auflage und zum sicheren schlupffreien Antrieb des Endlossubstrats 3 beiträgt.

Den eigentlichen Förderantrieb für das Endlossubstrat 3 bildet - wie bereits zu Fig. 1 beschrieben - die Bearbeitungstrommel 2, die mit einer Andruckwalze 21 unmittelbar vor dem Abheben der zur Aufwicklerrolle 44 rücklaufenden Substratbahn 32 das Endlossubstrat 3 schlupffrei mitnimmt. Die zur Bearbeitungstrommel 2 hinlaufende Substratbahn 31 und die von der Bearbeitungstrommel 2 rücklaufende Substratbahn 32 können dabei eine völlig gleiche räumliche Struktur von Umlenkrollen 42, Tänzerrolle 43 und Tänzerrollenführung aus Hebeleinrichtung 45, druckgesteuertem Zylinder 46 und Reglereinheit 47 aufweisen. In diesem Beispiel enthalten beide Substratbahnen 31, 32 eine Regelschleife 473, bei der die Störgröße der Auslenkung der jeweiligen Tänzerrolle 43 mittels eines Dehnungsmessstreifens 474 erfasst wird. Die Regelung der Drehgeschwindigkeiten der Abwicklerrolle 41 und der Aufwicklerrolle 44 erfolgt daraufhin in gleicher Weise, wie bereits zu Fig. 1 beschrieben.

Aufgrund der großflächigen Auflage des Endlossubstrats 3 entlang des Umfangs der Bearbeitungstrommel 2 kann die Registriereinheit 12 zur Erfassung von Zielmarken 33 (nur in Fig. 5, 6, 8, und 9 gezeigt) gegenüber dem Bearbeitungsstrahl L, der von der Strahlungsquelle 11 innerhalb einer Axialebene A der Bearbeitungstrommel 2 linear gescannt wird, in einer zur Axialebene A der Bearbeitungstrommel 2 parallelen Registrierebene R (nur in Fig. 5 und 6 bezeichnet) angeordnet werden, um aus einer der Strahlungsquelle 11 gegenüberliegenden Position noch vor dem Beginn 35 des Kontaktbereichs 36 des Endlossubstrats 3 an der Bearbeitungstrommel 2 insbesondere auch perforierte Zielmarken 33 unter Rückseitenbeleuchtung 122 aufnehmen zu können. Diese gegenüberliegende Parallelpositionierung ermöglicht eine einfache Justage von Strahlungsquelle 11 und Registriereinheit 12 sowie eine Zielmarkenerfassung für die Ausrichtung des Bestrahlungsmusters "On the Fly", indem die Ausrichtung eines gewünschten Bestrahlungsmusters in der Steuerungseinheit 13 rechentechnisch korrigiert und entlang der Scanlinie des linienförmig gescannten Bearbeitungsstrahls L durch direkte Steuerung der Strahlungsquelle 11 angepasst werden kann.

Dabei dreht sich die Bearbeitungstrommel 2 hochgenau synchronisiert zum zeilenweise eingestrahlten Bearbeitungsmuster der Strahlungsquelle 11 (vergleichbar mit der Synchronisation eines Tischvorschubes in plattenförmigen Direktbelichtungssystemen, wie z. B. in Produktfamilien "Paragon", "Xpress" oder "Nuvogo" der Fa. Orbotech, IL). Die Zielmarken 33 werden in diesem Beispiel an der Unterseite der Bearbeitungstrommel 2 erfasst und liefern die erfassten Daten der Zielmarken 33 für eine mehr als "180° später" stattfindende Bestrahlung. Für eine Registrierung der Zielmarken 33 zur Strahlungsbearbeitung müssen vor der 180°-Drehbewegung wenigstens zwei Paare von Zielmarken 33 (d.h. vier Targets) auf dem Endlossubstrat 3 erfasst werden, um die Strahlungsbearbeitung zweidimensional genau in dem relevanten Bereich des Endlossubstrats 3 durchzuführen. Dazu sind innerhalb einer zur Axialebene A parallelen Registrierebene R (nur in Fig. 5 und 6 gezeichnet) mehrere Kameras 121 angeordnet, die durch die Registrierebene R hindurch bewegte Zielmarken 33 gleichzeitig erfassen.

Die gesamte Bearbeitungslänge entlang der Transportrichtung des Endlossubstrats 3 ist unbegrenzt, d.h. ein Bearbeitungs-Job, der einen kompletten Leiterplattennutzen 38 (nur in Fig. 9 gezeichnet) umfasst, kann aus beliebig vielen durch Zielmarken 33 definierten Bereichen des Endlossubstrats 3 bestehen. Unter einem Leiterplattennutzen 38 wird eine technologisch optimierte Multi-Leiterplatten-Anordnung verstanden, die insbesondere bezüglich der Gesamtfertigungskosten für eine konkrete Leiterplattenserie (ein Fertigungslos) im Hinblick auf Bauelementebestückung, technologisch erforderlichen Rand, Löt- und Vereinzelungsprozesse etc. als ein zusammengefasstes Leiterplatten-Layout realisiert ist.

Über die durch die Zielmarken 33 vorgegebenen Flächen hinaus kann ebenfalls bestrahlt werden, indem die zuvor gewonnenen geometrischen Registrierungsdaten extrapoliert werden. Es ist aber ebenso möglich, auch noch weitere vorhandene Zielmarken 33 innerhalb eines Leiterplattennutzens 38 (nur in Fig. 9 gezeichnet) abschnittsweise aufzunehmen und für eine redundante, genauigkeitserhöhende Positionszuweisung für den Bearbeitungsstrahl L zu verwenden, wie weiter unten zu Fig. 9 noch genauer erläutert wird.

In Fig. 3 ist eine weitere vorteilhafte Ausgestaltung der Vorrichtung dargestellt. Dabei zeigt die Teilabbildung a) von Fig. 3 im Wesentlichen den gleichen räumlich kompakt gestalteten Aufbau der Vorrichtung gemäß Fig. 2 mit dem Unterschied, dass ein separat in y-Richtung verschiebbarer Schlitten 25 die Bearbeitungstrommel 2 mit zugehörigem Antrieb 22, Andruckwalze 21, Umlenkrolle(n) 42 und je einem Justiermittel 23 und 24 für die Registriereinheit 12 und den linienförmig gescannten Bearbeitungsstrahl L der Strahlungsquelle 11 trägt.

Zur Vorrichtungskalibrierung von Kameras 121 (nur in Fig. 5 und 6 bezeichnet) und Bearbeitungsstrahl L (unabhängig von der Kalibrierung während Service oder Wartung) kann die Bearbeitungstrommel 2 parallel in Richtung der Abwicklerrolle 41 und der Aufwicklerrolle 44 verschoben werden. Mechanisch gekoppelt sind Justiermittel 23 und 24 (sog. JIGs in Form von Metrologieskalen), die gleichzeitig mit dem Verschieben der Bearbeitungstrommel 2 unter den gescannten Bearbeitungsstrahl L bzw. über die Kameras 121 gelangen. Mit Hilfe dieser Metrologieskalen der Justiermittel 23 bzw. 24 erfolgt ein separater metrologischer Abgleich des Bearbeitungsstrahls L (beim "Abscannen") sowie der Kameras 121 (beim Registrieren in Bezug auf Positionierung und Bildaufnahme).

Das Ergebnis des Verschiebens des Schlittens 25 zeigt die Teilabbildung b) von Fig. 3, wobei der Schlitten 25 so verschoben ist, dass die Bearbeitungstrommel 2 so weit aus der Ebene des gescannten Bearbeitungsstrahls L herausgefahren ist, dass die Justiermittel 23 für die Kameras 121 und die Justiermittel 24 für den Bearbeitungsstrahl L an die vorherige Position der gegenüberliegenden Auftreffpunkte auf der Bearbeitungstrommel 2 gelangt sind. Die ursprüngliche Position des Schlittens 25 mit der Bearbeitungstrommel 2 und der Andruckwalze 21 sowie den Justiermitteln 23 und 24 ist zur Darstellung des Verschiebeweges dünn gestrichelt eingezeichnet. Bei - in Bearbeitungspausen - ausgefahrener Position der Bearbeitungstrommel 2 werden anhand der Justiermittel 23 und 24 die Justagen des Bearbeitungsstrahls L und der Registriereinheit 12 vorgenommen bzw. deren Einstellungen überprüft. Außerdem kann in dieser Position die Bearbeitungstrommel 2, z. B. für Wartungszwecke, unkompliziert ausgetauscht werden.

Mit dem verschiebbaren Schlitten 25 sind folgende Funktionen durchführbar:
1) Kalibrierung der Kameras 121 zur Registrierung von Zielmarken 33 (nur in Fig. 5, 6 und 8 gezeichnet), wie oben zur Teilabbildung a) von Fig. 3 beschrieben,
2) Fokussierung von Strahlungsquelle 11 und Registriereinheit 12 für den Bestrahlungsprozess zur Anpassung an unterschiedliche Materialdicken des Endlossubstrats 3, was in Fig. 4 für kleine Substratdicke in Teilabbildung a) und für große Substratdicke in Teilabbildung b) detailliert gezeigt ist, und
3) Kalibrierung der geometrischen Strahlablenkung des Bearbeitungsstrahls L quer zur Transportrichtung des Endlossubstrats 3 (x-Richtung) mittels Kalibriermarken 271 und 272 auf den Randbereichen 26 der Bearbeitungstrommel 2, wie zu Fig. 5 und 6 genauer beschrieben.

In einer Ausführung der Erfindung gemäß Fig. 4 wird zur Fokusanpassung gemäß obigem Punkt 2) die mechanische Drehachse D der Bearbeitungstrommel 2 in einer Standardeinstellung der Vorrichtung (Teilabbildung a) genau in die von dem gescannten Bearbeitungsstrahl L aufgespannte Axialebene A (nur in Fig. 5 und 6 gezeichnet) gelegt, um das System aus Strahlungsquelle 11 und Registriereinheit 12 genau auf die kleinste zu verarbeitende Dicke des Endlossubstrats 3 zu fokussieren, damit beim Einsatz dickerer Materialien durch eine y-Verschiebung der Bearbeitungstrommel 2 (um wenige Millimeter) der Abstand zwischen der Fokuslinie des Bearbeitungsstrahls L an der Trommeloberseite um eine Fokusänderung Δz₁ vergrößert und der Abstand der Fokuspunkte der Kameras 121 (nur in Fig. 5 und 6 bezeichnet) der Registriereinheit 12 an der Trommelunterseite um eine Fokusänderung -Δz₂ angepasst werden kann. Durch diese Maßnahme ist eine einfache Fokussierungsanpassung möglich, insbesondere zur Anpassung an Endlossubstrate 3 bis zu Dicken von einigen 100 µm, vorzugsweise in einem Bereich von 20 µm bis 200 µm, besonders bevorzugt von 30 µm bis 120 µm, ohne eine unzulässig große Abweichung von der senkrechten Ausrichtung des Bearbeitungsstrahls L gegenüber der Umfangsfläche der Bearbeitungstrommel 2 zu erreichen. Gleichzeitig mit der Fokusänderung Δz₁ des Bearbeitungsstrahls L ändern sich vorteilhaft auch die Fokuslagen der Kameras 121 der Registriereinheit 12 für die Registrierung der Zielmarken 33 (nur in Fig. 5 gezeichnet). Dies erfolgt mit gleicher Tendenz, aber unterschiedlicher Richtung (Fokusänderung -Δz₂) gegenüber der Rückseitenbeleuchtung 122 des Endlossubstrats 3, wenn die Registrierebene R, die durch die optischen Achsen der Kameras 121 der Registriereinheit 12 aufgespannt wird, zur Axialebene A parallel und so ausgerichtet ist, dass sich mit der Verschiebung der Drehachse D der Luftspalt 34, der in diesem Beispiel für die Rückseitenbeleuchtung 122 von perforierten Zielmarken 33 vorgesehen ist, in gleichem Maße verringert. Dieselbe Verschiebung der Drehachse D der Bearbeitungstrommel 2 kann in der Ausführung von Fig. 4-6 auch zur Fokussierung bei Auflichtbeleuchtung 123 (in Fig. 5 und 6 nicht gezeichnet) verwendet werden.

Zur Erläuterung einer dynamischen Kalibrierung des gescannten Bestrahlungsstrahls L und der Kameras 121 der Registriereinheit 12 wird auf Fig. 5 Bezug genommen. Dynamische Kalibrierungen können während des Belichtungsprozesses der Strahlbearbeitung oder auch unabhängig davon statt finden.

Die Vorrichtung ist auf eine maximale Bahnbreite des Endlossubstrats 3 von 520 mm ausgelegt, die in der Leiterplattenindustrie typisch ist, insbesondere für flexible gedruckte Schaltkreise (Flex PCB - Flexible Printed Circuit Boards). Die Bearbeitungstrommel 2 ist demgegenüber breiter und trägt am Umfang an beiden äußeren Randbereichen 26 ein in die Oberfläche eingelassenes Stahlband 27 mit primären Kalibriermarken 271 und einer Photochrombeschichtung. Die primären Kalibriermarken 271 können während des normalen Vorrichtungsbetriebs durch vorzugsweise zwei bewegliche Kameras 121 der Registriereinheit 12 (im Kamerakoordinatensystem) erfasst werden und generieren nach entsprechender Datenverarbeitung in der Steuerungseinheit 13 und nach einer Drehung der Bearbeitungstrommel 2 um mindestens 180° eine Belichtung mittels des gescannten Bearbeitungsstrahls L zur Erzeugung einer sekundären, transienten Kalibriermarke 272 (im Strahlungsquellenkoordinatensystem) über der primären Kalibriermarke 271. Durch den Photochromeffekt der Beschichtung des Stahlbandes 27 entsteht ein transientes Belichtungsbild der sekundären Kalibriermarke 272, sodass bei einer weiteren Drehung der Bearbeitungstrommel 2 auf die Position der Registriereinheit 12 im Idealfall zwei übereinander liegende Marken, aufgenommen mit der gleichen Kamera 121 wie zuvor, detektiert werden können. Die Kalibriermarken 271 und 272 sind vorzugsweise als Kombination aus Punkt-Ring oder aus Ring-Ring (verschiedener Durchmesser) ausgelegt, sodass die Abweichung beider berechneten Mittelpunkte 273 bzw. 274 den aktuellen geometrischen Versatz der Registriereinheit 12 (Kameras 121) und des gescannten Bearbeitungsstrahls L der Strahlungsquelle 11 (hier: Laser 14) ergeben.

Eventuelle Positionierfehler des in Fig. 5 als Strahlungsquelle 11 eingesetzten Lasers 14 (insbesondere des nicht separat gezeichneten Scanners des Lasers 14) bei der Bearbeitung mittels des Bearbeitungsstrahls L können auf diese Weise einfach durch Berechnung korrigierter Daten innerhalb des laufenden Bearbeitungsverfahrens von der Registrierung zur Bearbeitung eliminiert werden.

Der Scanbereich der Strahlungsquelle 11 ist außerdem breiter als die gesamte Bearbeitungstrommel 2, sodass zwei seitlich, d.h. außerhalb des Randbereichs 26 der Bearbeitungstrommel 2 angeordnete Photodetektoren 28 die aktuell verfügbare Strahlungsenergie messen können. Diese Messung dient zur Regelung bzw. Kalibrierung der Leistung des als Strahlungsquelle 11 verwendeten Lasers 14.

Fig. 5 zeigt in den Randbereichen 26 der Bearbeitungstrommel 2 jeweils ein Stahlband 27 mit einer photoempfindlichen Beschichtung, z. B. Photochrombeschichtung, in der die sekundären transienten Kalibriermarken 272 durch Belichtung mit dem Bearbeitungsstrahl L des Lasers 14 erzeugt werden, die in der Gesamtansicht als dunkle Kreise in regelmäßiger Folge dargestellt sind. Die primären Kalibriermarken 271, von denen im vergrößerten Detailausschnitt lediglich eine als heller Ring gezeichnet ist, sind im Stahlband 27 selbst (z.B. durch mechanische, chemische oder optische Verfahren oder Kombinationen davon) eingebracht. Die Erzeugung der sekundären Kalibriermarken 272 erfolgt durch Belichtung einer Kreislinie (oder einer anderen zentralsymmetrischen geometrischen Figur), die in der Photochrombeschichtung des Stahlbandes 27 zunächst ein latentes Bild erzeugt.

Mittels einer der Kameras 121 kann bei der Anwendung der Kalibriermarken 271 und 272 ein beispielsweise heller kleiner Ring als vorgegebene primäre Kalibriermarke 271 erfasst werden, während aufgrund eines Farbumschlags der belichteten sekundären Kalibriermarke 272 der große Ring beispielsweise als transient sichtbarer dunkler Ring der zuvor erfolgten Kreisringbelichtung der sekundären Kalibriermarke 272 zu sehen ist. Die derart transient sichtbare sekundäre Kalibriermarke 272 verschwindet nach wenigen Minuten von selbst, sodass die gleiche Stelle erneut für die Belichtung der latent erzeugten Ringmuster benutzbar ist. Für die Erfassung der primären und sekundären Kalibriermarken 271 und 272 ist eine Kamerabeleuchtung in den Kameras 121 enthalten, die - obwohl stets inhärent in den Kameras 121 vorhanden - in Fig. 5 und 6 nicht eingezeichnet ist, weil dort nur die Kamerapositionierung bei Rückseitenbeleuchtung 122 für perforierte Zielmarken 33 (nicht gezeichnet) dargestellt ist, wofür keine Auflichtbeleuchtung 123 benötigt wird. Praktisch ist die Auflichtbeleuchtung 123 aber für die Kalibrierung des Bearbeitungsstrahls L unter Verwendung der Randbereiche 26 der Bearbeitungstrommel 2 genauso, wie in der für die Auflicht-Registrierung äquivalenten Darstellung von Fig. 8 gezeichnet, vorhanden.

Im Beispiel der vergrößerten Detailabbildung von Fig. 5 sind die Abweichungen Δx, Δy zwischen Belichtung des ringförmigen Bestrahlungsmusters und der zugeordneten Kamera 121 extrem groß. Ziel der Kalibrierung ist es, nur wenige Mikrometer, vorzugsweise ≤ 20 µm, besonders bevorzugt ≤ 10 µm, als Abweichungen zuzulassen.

Besonderheiten der Ausführung von Fig. 5 bestehen darin, dass die Kameras 121 der Registriereinheit 12 wenigstens für die dynamische Kalibrierung (aber nicht darauf beschränkt) in x-Richtung beweglich sind. Zum Zwecke der Kalibrierung werden sie an den Randbereich 26 der Bearbeitungstrommel 2 gefahren, um dort ein metrologisch unverzerrtes Bild der Kalibriermarken 271 und 272 aufnehmen zu können. Des Weiteren sind Photodetektoren 28 zur Messung der im Randbereich 26 (und darüber hinaus) auftreffenden Strahlungsenergie der Strahlungsquelle 11 parallel zur Drehachse D der Bearbeitungstrommel 2 so angeordnet, dass diese direkt neben der Bearbeitungstrommel 2 in Einfallsrichtung des Bearbeitungsstrahls L ausgerichtet sind, sodass sie ein Maß für die auf die Bearbeitungstrommel 2 einfallende Intensität ermitteln können.

Die Randbereiche 26 der Bearbeitungstrommel 2 mit der photoempfindlichen Beschichtung lassen aber auch noch ein alternatives permanent durchführbares Kalibrierverfahren zu. In diesem Fall wird auf die dauerhafte Einbringung der primären Kalibriermarken 271 verzichtet und stattdessen mittels des Lasers 14 ohne Vorgabe durch die Registriereinheit 12 eine belichtete primäre Kalibriermarke 271 erzeugt (hergestellt im Bestrahlungsquellenkoordinatensystem). Nach Drehung der Bearbeitungstrommel 2 bis zur Registriereinheit 12 wird diese vorgegebene primäre Kalibriermarke 271 im Kamerakoordinatensystem erfasst und die Position für die Belichtung der berechneten sekundären Kalibriermarke 272 vorgegeben. Nach der Belichtung der transienten sekundären Kalibriermarke 272 durch den Bearbeitungsstrahl L auf mindestens einen der Randbereiche 26 erfolgt dann die Aufnahme der zwei, im Idealfall übereinander belichteten Kalibriermarken 271 und 272 durch die Kamera(s) 121 der Registriereinheit 12. Die ermittelte Differenz der Kalibriermarken 271 und 272 kann dann wiederum für die Korrektur der Position des Bestrahlungsmusters auf dem Endlossubstrat 3 verwendet werden.

Fig. 6 zeigt eine modifizierte Ausführung der dynamischen Kalibrierung gemäß Fig. 5 für die Strahlbearbeitungseinrichtung 1 mit der dazwischen liegenden Bearbeitungstrommel 2. Der Aufbau der Bearbeitungstrommel 2 ist dabei unverändert gegenüber Fig. 5. In dieser Ausführung ist aber das Endlossubstrat 3 nicht nur am Rand der hinlaufenden Substratbahn 31 mit Zielmarken 33 versehen, sondern auch in deren Mitte oder beliebigen Zwischenpositionen, um - wie bei rechteckigen Schaltkreisfolien - geometrische Verzerrungen auch in der Mitte eines Leiterplattennutzens 38 (nur in Fig. 9 gezeigt) zu erfassen, für dessen Ausrichtung in diesem Beispiel mit drei Kameras 121 der Registriereinheit 12 die Zielmarken 33 in der Konstellation 1-2-1 aufzunehmen sind. Dabei können auch noch mehr als drei Kameras 121 eingesetzt werden. Weiterhin sind auch Zielmarkenkonstellationen von 2-4-2 und 2-2-2 mit dieser Anordnung der Kameras 121 erfassbar. Außerdem können die beiden äußeren Kameras 121 bei fester Positionierung auch die primären und die sekundären Kalibriermarken 271 bzw. 272 auf dem Stahlband 27 im Randbereich 26 der Bearbeitungstrommel 2 aufnehmen, um ohne Kameraverschiebungen bei laufendem Bearbeitungsbetrieb die korrekte Ausrichtung zwischen Registrierung durch die Registriereinheit 12 und Bearbeitung (z.B. Belichtung) durch den Laser 14 zu überprüfen und gegebenenfalls wieder herzustellen. Des Weiteren ist in der Gestaltung gemäß Fig. 5 die Erfassung der Intensität oder Leistung des Lasers 14 mittels Photodetektoren 28 an den Stirnseiten der Bearbeitungstrommel 2 so ausgeführt, dass zur Messung der im Randbereich 26 (und darüber hinaus) auftreffenden Strahlungsenergie des Lasers 14 je ein Photodetektor 28 parallel zur Drehachse D der Bearbeitungstrommel 2 ausgerichtet ist und je einen vorgeordneten Umlenkspiegel 281 zur Strahlungsumlenkung aufweist.

In Fig. 7 ist eine weitere Ausführung der Erfindung schematisch dargestellt, bei der die Gestaltung der last- und verzerrungsarmen Führungen der hin- und rücklaufenden Substratbahnen 31 und 32 nach Fig. 2 für eine Auflicht-Registrierung von aufgedruckten Zielmarken 33 lediglich modifiziert ist. Eine Auflicht-Registrierung ist im Übrigen auch in allen übrigen hier mit Rückseitenbeleuchtung 122 beschriebenen Beispielen ergänzend oder alternativ für gedruckte oder anderweitig an der Oberseite aufgebrachte Zielmarken 33 möglich, auch wenn dies nicht ausdrücklich erwähnt oder gezeichnet ist.

Bei der Ausführungsvariante nach Fig. 7 ist die Bearbeitungstrommel 2 wiederum als separate Einheit austauschbar bzw. verschiebbar und weist dafür zwei auf dem Schlitten 25 befestigte Umlenkrollen 42 sowie die zu Fig. 3 beschriebenen Justiermittel 23 und 24 für Strahlungsquelle 11 und Registriereinheit 12 auf. Der Bearbeitungsstrahl L und die Registriereinheit 12 sind in dieser Ausführung exakt diametral gegenüberliegend entlang der Axialebene A der Bearbeitungstrommel 2 angeordnet, wie in der perspektivischen Darstellung von Fig. 8 deutlicher zu erkennen ist. Alle übrigen Funktionen des Schlittens 25 sind, wie zu Fig. 3 und Fig. 4 beschrieben, beibehalten.

Darüber hinaus sind die Aufwickler- und Abwicklerrollen 41 und 44 so gestaltet, dass sie unabhängig voneinander mit beliebiger Drehrichtung verwendet werden können, sodass eine betriebsseitige freie Wahl sowohl der Bestrahlungsseite des Endlossubstrats 3 von der Abwicklerrolle 41 als auch der Lage der bearbeiteten Seite als Innen- oder Außenseite bei der Aufwicklung an der Aufwicklerrolle 44 besteht. Diese Möglichkeit ist in Fig. 7 durch eine durchgezogene und eine gestrichelte Linie der hinlaufenden Substratbahn 31 und der rücklaufenden Substratbahn 32 des Endlossubstrats 3 an der Abwicklerrolle 41 und an der Aufwicklerrolle 44 dargestellt.

Des Weiteren ist in Fig. 7 an der Bearbeitungstrommel 2 auf eine Andruckwalze 21 verzichtet worden. Dafür gibt es zwei unabhängige Gründe von hier gezeichneten Ausführungsdetails. Einerseits kann ein extrem großer Kontaktbereich 36 des Endlossubstrats 3 an der Peripherie der Bearbeitungstrommel 2 vorgesehen sein, sodass der Kontaktbereich 36 vom Beginn 35 bis zum Ende 37 hier etwa einen Bogen von (3/2)·π der Bearbeitungstrommel 2 umspannt, und andererseits kann eine zusätzliche Vakuumansaugung des Endlossubstrats 3 erfolgen, für die eine Vakuumeinheit 9 an eine poröse oder mit Kanälen versehene Vakuumstruktur 29 der Bearbeitungstrommel 2 angeschlossen ist. Beide Fälle, die nicht nur alternativ, sondern auch gemeinsam einsetzbar sind, dienen der Vermeidung eines unerwünschten Schlupfes des Endlossubstrats 3 auf der angetriebenen Bearbeitungstrommel 2.

Fig. 8 verdeutlicht die bereits zu Fig. 7 erwähnte Zusammenlegung der Ebenen für die Strahlbearbeitung zur Mustereinbringung und die Registrierung der Zielmarken 33 in einer gemeinsamen Axialebene A der Bearbeitungstrommel 2. Voraussetzung dafür sind Zielmarken 33, die in die Oberfläche des Endlossubstrats 3 eingebracht und unter Auflichtbeleuchtung 123 problemlos erfassbar sind. Die in Fig. 8 stilisiert gezeichnete Auflichtbeleuchtung 123 ist üblicherweise in die Kameras 121 integriert und äußerlich nicht sichtbar. Es kommen dieselben zu Fig. 5 beschriebenen Verfahren zur dynamischen Kalibrierung der Strahlungsquelle 11 (bzw. des Lasers 14) gegenüber der Registriereinheit 12 zur Anwendung. Ebenso können die beweglichen Kameras 121 durch fest installierte Kameras 121 ersetzt werden, die angepasst an die Positionsvorgaben der Zielmarken 33 des Endlossubstrats 3 und der Kalibriermarken 271 und 272 der Bearbeitungstrommel 2 angeordnet sind.

Bei der Kalibrierung der Koordinatensysteme von Registriereinheit 12 und Bearbeitungsstrahl L wird für die Ausführung gemäß Fig. 8 angenommen, dass die primäre Kalibriermarke 271 genauso wie die sekundäre Kalibriermarke 272 durch Belichtung mindestens einen der photochrombeschichteten Randbereiche 26 der Bearbeitungstrommel 2 mittels des Bearbeitungsstrahls L transient erzeugt wird. In diesem Fall wird die dauerhafte Einbringung der primären Kalibriermarken 271 ersetzt durch eine mittels der Strahlungsquelle 11 ohne Positionsvorgabe (im Strahlungsquellenkoordinatensystem) belichtete primäre Kalibriermarke 271. Nach Drehung der Bearbeitungstrommel 2 um 180° wird die so vorgegebene primäre Kalibriermarke 271 z.B. als kleiner schwarzer Ring (wie in der Detailabbildung von Fig. 8 gezeichnet) oder aber als Punkt, Quadrat, gleichseitiges Dreieck oder eine andere punktsymmetrische Figur, im Kamerakoordinatensystem der Registriereinheit 12 erfasst und die Position für die Belichtung der berechneten sekundären Kalibriermarke 272 vorgegeben. Nach der Belichtung der in ihrer Form und/oder Größe von der primären Kalibriermarke 271 abweichenden sekundären Kalibriermarke 272 durch den Bearbeitungsstrahl L auf den mindestens einen Randbereich 26 erfolgt dann die Aufnahme der zwei im Idealfall übereinander belichteten Kalibriermarken 271 und 272 durch die Kamera(s) 121 der Registriereinheit 12. Die ermittelte Differenz der Kalibriermarken 271 und 272 kann dann wiederum für die Korrektur der Position des Bestrahlungsmusters auf dem Endlossubstrat 3 verwendet werden.

In Fig. 9 ist eine verbesserte Anpassung der Schaltkreisdaten der in das Endlossubstrat 3 einzubringenden Bestrahlungsmuster an etwaige Verzerrungen des Endlossubstrats 3, insbesondere für unterschiedliche Leiterplattennutzen 38 (Mischnutzen auf dem Endlossubstrat 3) gezeigt. Dabei sind mehrere separate Schaltkreise oder Leiterplattennutzen 38 verzerrungsfrei zu belichten. Obwohl das Endlossubstrat 3 eine erhöhte Anzahl von Zielmarken 33 aufweist, sind die Zielmarken 33 nicht Bestandteil von Kantenpositionen bestimmter Schaltkreise oder Leiterplattennutzen 38, sondern alle Leiterplattennutzen 38 des in Fig. 9 stilisiert dargestellten Mischnutzens aus unterschiedlichen Leiterplattennutzen 38 sind in einem verknüpften Satz von CAM-Daten (engl.: Computer-Aided Manufacturing Data) vereinigt. Die erhöhte Anzahl von Zielmarken 33 ist also keine Maßnahme, um den einzelnen Schaltkreisen oder Leiterplattennutzen 38 eine spezifische Lage zuzuordnen, sondern sie stehen in fester Beziehung zu eng benachbarten streifenförmigen Bereichen des verknüpften CAM-Datensatzes des Mischnutzens. Die Zielmarken 33 sind somit definierten schmalen Abschnitten "Bereich 1" bis "Bereich 9" des Endlossubstrats 3 zwischen den Positionen der Registriereinheit 12 und des gescannten Bearbeitungsstrahls L zuordenbar.

Geometrische Verzerrungen des flexiblen Endlossubstrats 3 haben gewöhnlich ein sich langsam und kontinuierlich änderndes Verhalten, sodass diese - wenn sie ausreichend genau erfassbar sind - bei der Belichtung der Schaltkreise oder Leiterplattennutzen 38 korrigierend einberechnet werden können.

Dazu wird berücksichtigt, dass das im Abschnitt "Bereich 1" zu belichtende Bestrahlungsmuster für die gewünschten Leiterplattennutzen 38 nicht nur auf Basis der im Abschnitt "Bereich 1" registrierten Zielmarken 33 berechnet wird, sondern zusätzlich unter Berücksichtigung der Zielmarken 33 der Abschnitte "Bereich 2" bis "Bereich n" verbessert werden kann, wobei "Bereich n" im gezeichneten Beispiel der Abschnitt "Bereich 7" sein könnte. Die konkrete Anzahl n der zur Glättung von verzerrten Zielmarkenpositionen mit einbezogenen Abschnitte hängt nicht nur von der Komplexität des Bestrahlungsmusters, sondern vor allem von der Größe der mit Zielmarken 33 verknüpften Abschnitte und von der Anzahl der mit einem Leiterplattennutzen 38 überstrichenen Abschnitte ab. Es kann aber auch eine geringere Anzahl von einberechneten Abschnitten, z.B. "Bereich 1" bis "Bereich 5", eine deutliche Genauigkeitssteigerung durch Mittelung der erfassten Positionsabweichungen der Zielmarken 33 bewirken. Dadurch ist eine Verbesserung der gesamten lokalen Genauigkeit der Mustereinbringung gleich für mehrere benachbarte Leiterplattennutzen 38 möglich, da der Übergang von einem Abschnitt zum nächsten "weicher" ist und somit Sprungstellen bei der Korrektur des Bestrahlungsmusters vermieden werden können.

In Fig. 10 ist eine weitere Ausführung der Erfindung mit einer Regelschleife 473 auf Basis einer Wegänderung dargestellt, die als inkrementale Längenänderung der Schubstangen der druckgesteuerten Zylinder 46 gemessen wird. Das Endlossubstrat 3 ist dabei - wie zu Fig. 7 beschrieben - in beliebiger Weise von der Abwicklerrolle 41 über Umlenkrollen 42 aufnehmbar, wird anschließend mittels Bahnkantenreglern 6 in Querrichtung ausgerichtet und über die Cleaner-Einheit 5 und zwischen weiteren Umlenkrollen 42 durch die "eingefrorene" Tänzerrolle 43 definiert gestrafft, bevor es der auf einem beweglichen Schlitten 25 montierten Bearbeitungstrommel 2 zugeführt wird. Auf dem Schlitten 25 ist das Endlossubstrat 3 über zwei Umlenkrollen 42 so geführt, dass das Endlossubstrat 3 mit der Bearbeitungstrommel 2 vom Beginn 35 bis zum Ende 37 eines Kontaktbereichs 36 einen Winkel von ca. 240° einschließt. Folglich kann hier, wie in Fig. 7, auf eine Andruckwalze 21 verzichtet werden. Obwohl hier nicht gezeichnet, kann auch in dieser Ausführung der Erfindung eine mit Vakuumstrukturen 29 versehene Bearbeitungstrommel 2 für die zusätzliche Vakuumansaugung des Endlossubstrats 3 sorgen, wenn eine Vakuumeinheit 9, wie in Fig. 7 gezeigt, an die Bearbeitungstrommel 2 angeschlossen ist.

In einer Axialebene der Bearbeitungstrommel 2 etwa 10° vor dem Beginn 35 des Kontaktbereichs 36 ist die Registriereinheit 12 auf die hinlaufende Substratbahn 31 so eingerichtet, dass infolge einer in den Luftspalt 34 zwischen Substratbahn 31 und Bearbeitungstrommel 2 einfallenden Rückseitenbeleuchtung 122 die Registrierung von perforierten Zielmarken 33 (nur in Fig. 5, 6, 8 und 9 gezeichnet) möglich ist. Aufgrund des ausgedehnten Kontaktbereichs 36 ist in diesem Beispiel die Andruckwalze 21 entfallen und die für den Bearbeitungsstrahl L gewählte Axialebene A (nur in Fig. 5, 6 und 8 bezeichnet) kurz vor dem Ende 37 des Kontaktbereichs 36 eingerichtet.

Fig. 11 zeigt eine gegenüber Fig. 10 modifizierte Ausführung der Erfindung, bei der wie in Fig. 10 eine Wegänderung an den Schubstangen der druckgesteuerten Zylinder 46 in der jeweiligen Regelschleife 473 für die Antriebe 7 (nur in Fig. 12 bezeichnet) der Abwicklerrolle 41 und der Aufwicklerrolle 44 angewendet wird. Der Kontaktbereich 36 zwischen Endlossubstrat 3 und Bearbeitungstrommel 2 ist mittels zweier Umlenkrollen 42 auf einen Winkelbereich von ca. 225° ausgedehnt. Im Unterschied zu Fig. 10 sind die vom Bearbeitungsstrahl L aufgespannte Axialebene A und die Registrierebene R der Registriereinheit 12 parallel zueinander ausgerichtet (in einer Weise analog zu Fig. 5 und 6), wobei zur Registrierung erneut eine Rückseitenbeleuchtung 122 im Luftspalt 34 zwischen hinlaufender Substratbahn 31 und Bearbeitungstrommel 2 vorhanden ist.

Als Besonderheit weist der stilisiert gezeichnete Schlitten 25 (mit Punkt-Punkt-Strich-Linie umrandet) an der Bearbeitungstrommel 2 zwischen Registriereinheit 12 und Bearbeitungsstrahl L eine Andruckwalze 21 auf, die zugleich mit einer Cleaner-Rolle 51 in Kontakt steht. Dadurch ist in unmittelbarer Nähe der Strahlbearbeitung eine nochmalige oder erstmalige Reinigung der Oberfläche des Endlossubstrats 3 möglich. Die Cleaner-Einheit 5 zwischen Bahnkantenregelung 6 und Tänzerrolle 43 kann somit optional entfallen und ist deshalb nur gestrichelt gezeichnet.

Des Weiteren kann die in Fig. 11 vorhandene Andruckwalze 21 mit einem hochauflösenden Encoder 211 ausgestattet sein, mit dem - in Abhängigkeit von unterschiedlichen Dicken des Endlossubstrats 3 - die tatsächlich zwischen der Registriereinheit 12 und dem Bearbeitungsstrahl L zurückgelegte Länge der Materialoberfläche des Endlossubstrats 3 erfasst werden kann. Das ist für solche Fälle erforderlich, in denen eine von den Zielmarken 33 (nur in Fig. 5, 6, 8 und 9 gezeigt) unabhängige, korrekte Skalierungsmessung benötigt wird, beispielsweise um nach beliebig langen Bearbeitungslücken zwischen zwei Belichtungsmustern eine genau definierte Musterfortsetzung oder -wiederholung zu garantieren.

Die Skalierungsmessung kann auch durch ein oder mehrere separate Messräder (mit je einem hochauflösenden Encoder 211) oder durch eine Messung der Materialdicke mittels Höhenmessung an der Bearbeitungstrommel 2 und Umrechnung der transportierten Materiallänge über die Änderung des Durchmessers erfolgen. Für die Messung der Materialdicke kommen in diesem Fall zusätzlich ein Abstandssensor oder ein Höhensensor zur Anwendung (z. B. Laser-Triangulations-Sensoren der Typenreihe "optoNCDT 1320" der Fa. Micro-Epsilon, DE)

In Fig. 12 ist eine weitere Gestaltung der Erfindung in einem Maschinengehäuse 8 dargestellt, bei der die Ausführung gemäß Fig. 2 gespiegelt angeordnet ist. Zusätzlich sind Antriebe 7 und Stützelemente 81 als Black-Boxen sowie ein Bedienpanel 82 gezeichnet.

Diese Ausführung der Erfindung in einem geschlossenen Maschinengehäuse 8, das nur für die Ansicht der inneren Anordnung der in den Fig. 2 bis Fig. 7 schematisch gezeigten Komponenten der Erfindung geöffnet dargestellt ist, verdeutlicht die zu vergleichbaren Rolle-zu-Rolle-Bearbeitungsmaschinen (z.B. eingangs genannte US 2012/0241419 A1, JP 2015-188915 A etc.) erheblich verringerte Standfläche (Footprint).

Die wesentlich Raumersparnis kommt in diesem Maschinengehäuse 8 aufgrund der übereinander angeordneten Abwickler- und Aufwicklerrollen 41 und 44 zustande. Dadurch ist nicht nur der Wechsel der Materialrollen des Endlossubstrats 3 an derselben Seite des Maschinengehäuses 8 möglich, sondern auch die Führung der hinlaufenden und der rücklaufenden Substratbahnen 31 bzw. 32 nahezu parallel und in einer kompakten Substratführungseinheit 4 organisiert. Im Übrigen tragen auch die erfindungsgemäß aufgehängten Tänzerrollen 43 zur Raumeinsparung bei, weil für deren bestimmungsgemäße Funktion gegenüber den herkömmlich raumgreifenden linearen Achsbewegungen nur infinitesimal kleine Auslenkungen zur Auslösung der Regelung der Antriebe 7 der Abwickler- und Aufwicklerrollen 41 und 44 erforderlich sind. Bei der hier gezeichneten Variante sind die Hebeleinrichtungen 45 und die Reglereinheiten 47 wie in Fig. 1 auf Basis inkrementaler Winkelgeber 471 gezeichnet. Aber es können alle in den vorherigen Beispielen beschriebenen Messeinheiten zur Störgrößenerfassung ersatzweise zum Einsatz kommen. Die Strahlungsquelle 11, die auch hier als mit Laserscanner ausgestatteter Laser 14 (nur in Fig. 5, 6 und 8 bezeichnet) angenommen sein soll, ist in diametraler Gegenüberstellung zur Registriereinheit 12 angeordnet, sodass der Kontaktbereich 36 des Endlossubstrats 3 mit der Bearbeitungstrommel 2 über mehr als 180° auf der Mantelfläche der Bearbeitungstrommel 2 ausgedehnt ist. Eine zusätzliche Andruckwalze 21 kann für eine schlupffreie und verzerrungsarme Führung des Endlossubstrats 3 sorgen, wobei die Andruckwalze 21 optional einen hochauflösenden Encoder 211 aufweist, mit dem die real mit der Bearbeitungstrommel 2 transportierte Länge der Substratoberfläche des Endlossubstrats 3, wie zu Fig. 11 beschrieben, genau ermittelt werden kann.

Mit der erfindungsgemäßen Vorrichtung sind neben einer wesentlichen Verbesserung der kraftarmen Führung des Endlossubstrats 3 im Bereich der Bearbeitungstrommel 2, d.h. einer straffen Substratbahn 31, 32 bei der Zu- und Abführung des Endlossubstrats 3 um die Bearbeitungstrommel 2 ohne Schlupf, Kraftschwankungen und Verzerrungen der Substratbahn 31, 32 infolge des vernachlässigbar kleinen "Spiels" der Achsen der Tänzerrollen 43, also zusätzlich noch deutliche Einsparungen im Platzbedarf der gesamten Vorrichtung realisierbar.

### Bezugszeichenliste

- 1: Strahlbearbeitungseinrichtung
- 11: (linienförmige) Strahlungsquelle
- 12: Registriereinheit
- 121: Kamera
- 122: Rückseitenbeleuchtung
- 123: Auflichtbeleuchtung
- 13: Steuerungseinheit
- 14: Laser
- 2: Bearbeitungstrommel
- 21: Andruckwalze
- 211: hochauflösender Encoder
- 22: Antrieb (der Bearbeitungstrommel 2)
- 23, 24: Justiermittel (für Registriereinheit 12, Bearbeitungsstrahl L)
- 25: Schlitten
- 26: Randbereich
- 27: Stahlband (mit Photochrombeschichtung)
- 271: (primäre) Kalibriermarke
- 272: (sekundäre, transiente) Kalibriermarke
- 273: Mittelpunkt (der primären Kalibriermarke 271)
- 274: Mittelpunkt (der sekundären Kalibriermarke 272)
- 28: Photodetektor
- 281: Umlenkspiegel
- 29: Vakuumstruktur (der Bearbeitungstrommel 2)
- 3: Endlossubstrat
- 31, 32: (hinlaufende, rücklaufende) Substratbahn (des Endlossubstrats 3)
- 33: Zielmarken
- 34: Luftspalt
- 35: Beginn des Kontaktbereichs 36
- 36: Kontaktbereich (der Bearbeitungstrommel 2 mit dem Endlossubstrat 3)
- 37: Ende des Kontaktbereichs 36
- 38: Schaltkreis/Leiterplattennutzen
- 4: Substratführungseinheit
- 41: Abwicklerrolle
- 42: Umlenkrollen
- 43: Tänzerrolle
- 44: Aufwicklerrolle
- 45: Hebeleinrichtung
- 451: Schwenkachse
- 452: Hebelarm
- 46: (druckgesteuerter) Zylinder
- 47: Reglereinheit
- 471: (inkrementaler) Winkelgeber
- 472: Drehgeschwindigkeitsregler
- 473: Regelschleife
- 474: Dehnungsmessstreifen
- 475: inkrementaler Wegsensor
- 476: Zeilensensor
- 5: Cleanereinheit
- 51: Cleanerrolle (mit Andruckwalze 21 gekoppelt)
- 6: Bahnkantenregler
- 7: Antrieb
- 8: Maschinengehäuse
- 81: Stützelemente
- 82: Bedienpanel
- 9: Vakuumeinheit
- A: Axialebene (der Bearbeitungstrommel 2)
- R: Registrierebene
- D: Drehachse (der Bearbeitungstrommel 2)
- L: (linienförmig gescannter) Bearbeitungsstrahl
- Δx, Δy: Abweichung (der Kalibriermarken 271, 272)
- Δz₁,-Δz₂: Fokusänderung (des Bearbeitungsstrahls L; der Registriereinheit 12)

## Patentansprüche

1. Vorrichtung zur Mustereinbringung mittels Strahlung an einem aufgewickelten Endlossubstrat (3), bei der das Endlossubstrat (3) von einer Abwicklerrolle (41) über eine Bearbeitungstrommel (2) auf eine Aufwicklerrolle (44) rollbar geführt ist, wobei eine Registriereinheit (12) zur optischen Aufnahme von Zielmarken (33) und eine Strahlungsquelle (11) zum Einstrahlen eines Strahlungsmusters in zwei unterschiedlichen Richtungen auf die Bearbeitungstrommel (2) gerichtet sind, und eine Steuerungseinheit (13) zur Steuerung der Ausrichtung zwischen Strahlungsmuster und Endlossubstrat (3) und zur örtlichen Differenzierung des Strahlungsmusters vorhanden sind, wobei in der Steuerungseinheit (13) Mittel zur elektronischen Anpassung des Strahlungsmusters an von der Registriereinheit (12) aufgrund der Zielmarken (33) ermittelte Lageabweichungen des Endlossubstrats (3) vorhanden sind, wobei
- zwischen der Bearbeitungstrommel (2) und Abwicklerrolle (41) und Bearbeitungstrommel (2) und Aufwicklerrolle (44) jeweils eine Tänzerrolle (43) zur straffen Führung des Endlossubstrats (3) entlang eines definierten Kontaktbereichs (36) von wenigstens einem halben Umfang der Bearbeitungstrommel (2) vorhanden ist, um mittels eines Antriebs (22) der Bearbeitungstrommel (2) eine Förderbewegung von der Bearbeitungstrommel (2) über den definierten Kontaktbereich (36) schlupffrei auf das Endlossubstrat (3) zu übertragen,
- die Tänzerrollen (43) zu einer gestrafften Führung einer hinlaufenden und einer rücklaufenden Substratbahn (31; 32) des Endlossubstrats (3) mit einer konstanten Kraftwirkung im Gegenzug zum Kontaktbereich (36) an der Bearbeitungstrommel (2) eingerichtet sind, **dadurch gekennzeichnet, dass** Stabilisierungseinrichtungen (45, 46) zur Einstellung eines Gleichgewichts zwischen einer definierten Gegenkraft und der konstanten Kraftwirkung auf die Tänzerrolle (43) vorhanden und mit einer Messeinheit (471; 474; 475; 476) zur Aufnahme von Änderungen der Auslenkung der jeweiligen Tänzerrolle (43) verknüpft ist, und
- die Abwicklerrolle (41) und die Aufwicklerrolle (44) regelbare Antriebe (7) aufweisen, die in ihrer Drehgeschwindigkeit geregelt sind auf Basis von durch die Messeinheit (471; 474; 475; 476) erfassten Störungen des Kräftegleichgewichts an der Tänzerrolle (43).

2. Vorrichtung nach Anspruch 1, **dadurch gekennzeichnet, dass** die Stabilisierungseinrichtung eine Hebeleinrichtung (45) aufweist, an der die Tänzerrolle (43) zum Ausführen einer Schwenkbewegung angelenkt ist, und einen pneumatisch oder hydraulisch druckgesteuerten Zylinder (46) enthält, der an der Hebeleinrichtung (45) angelenkt ist, um das Gleichgewicht zwischen der definierten Gegenkraft und der konstanten Kraftwirkung auf die Tänzerrolle (43) zu halten, wobei die Hebeleinrichtung (45) eine Auslenkung der Tänzerrolle (43) entlang eines Kreisbogens ermöglicht.

3. Vorrichtung nach Anspruch 2, **dadurch gekennzeichnet, dass** die Messeinheit zur Aufnahme von Änderungen der Auslenkung der Tänzerrolle (43) als eines der folgenden Messelemente ausgebildet ist:
- als inkrementaler Winkelgeber (471) zur Messung von Winkeländerungen in einer Schwenkachse (451) der Hebeleinrichtung (45),
- als optischer Winkelgeber derart, dass mittels eines Lichtstrahls, der über einen Umlenkspiegel an einem Hebelarm (452) der Hebeleinrichtung (45) auf einen Zeilensensor (476) gerichtet ist, Winkeländerungen der Hebeleinrichtung (45) als Ortsänderungen des Lichtstrahls am Zeilensensor (476) erfassbar sind,
- als inkrementaler Wegsensor (475) zur Messung von linearen Längenänderungen der Schubstange des druckgesteuerten Zylinders (46), und
- als Dehnungsmessstreifen (474) zur Messung der Durchbiegung an einem Hebelarm (452) der Hebeleinrichtung (45).

4. Vorrichtung nach einem der Ansprüche 1 bis 3, **dadurch gekennzeichnet, dass** die Stabilisierungseinrichtungen (45, 46) an eine Reglereinheit (47) mit einer Regelschleife (473) zwischen der Messeinheit (471; 474; 475; 476) und einem Drehgeschwindigkeitsregler (472) der Abwicklerrolle (41) oder der Aufwicklerrolle (44) gekoppelt sind.

5. Vorrichtung nach einem der Ansprüche 1 bis 4, **dadurch gekennzeichnet, dass** in einer Substratführungseinheit (4) neben den Tänzerrollen (43) Umlenkrollen (42) vorhanden sind, die zur beliebigen Änderung der Ab- oder Aufwickelrichtung der Abwicklerrolle (41) oder der Aufwicklerrolle (44) vorgesehen sind.

6. Vorrichtung nach einem der Ansprüche 1 bis 5, **dadurch gekennzeichnet, dass** in einer Substratführungseinheit (4) neben den Tänzerrollen (43) Umlenkrollen (42) vorhanden sind, die zur Führung des Endlossubstrats (3) derart vorgesehen sind, dass die zur Bearbeitungstrommel (2) hinlaufende Substratbahn (31) und die rücklaufende Substratbahn (32) von und zu räumlich übereinander angeordneten Abwickler- und Aufwicklerrollen (41, 44) geführt sind.

7. Vorrichtung nach einem der Ansprüche 1 bis 6, **dadurch gekennzeichnet, dass** in einer Strahlbearbeitungseinrichtung (1) die Strahlungsquelle (11) mit einem linienförmigen Bearbeitungsstrahl (L) und die Registriereinheit (12) mit einem streifenförmigen Abtastbereich parallel zu einer Drehachse (D) der Bearbeitungstrommel (2) angeordnet und in unterschiedlichen Axialebenen auf je eine Mantellinie der Bearbeitungstrommel (2) oder in ein und derselben Axialebene (A) auf diametral gegenüberliegende Seiten der Bearbeitungstrommel (2) gerichtet sind.

8. Vorrichtung nach einem der Ansprüche 1 bis 6, **dadurch gekennzeichnet, dass** in einer Strahlbearbeitungseinrichtung (1) die Strahlungsquelle (11) mit einem linienförmigen Bearbeitungsstrahl (L) parallel zu einer Drehachse (D) und in einer Axialebene (A) der Bearbeitungstrommel (2) und die Registriereinheit (12) mit einem streifenförmigen Abtastbereich in einer zu der Axialebene (A) parallelen Registrierebene (R) auf gegenüberliegende Seiten der Bearbeitungstrommel (2) gerichtet sind, wobei die Registrierebene (R) entgegen der hinlaufenden Substratbahn (31) so weit vorgelagert ist, dass ein Luftspalt (34) zur Einstrahlung einer Rückseitenbeleuchtung (122) vor einem Beginn (35) des Kontaktbereichs (36) des Endlossubstrats (3) mit der Bearbeitungstrommel (2) vorhanden ist.

9. Vorrichtung nach einem der Ansprüche 1 bis8, **dadurch gekennzeichnet, dass** die Bearbeitungstrommel (2) auf einem beweglichen Schlitten (25) derart angebracht ist, dass ein linienförmiger Bearbeitungsstrahl (L) der Strahlungsquelle (11) und ein streifenförmiger Abtastbereich der Registriereinheit (12) durch die Bewegung des Schlittens (25) tangential auf jeweils eine weiter entfernte Mantellinie der Bearbeitungstrommel (2) verschiebbar sind, wodurch Fokussierungen des Bearbeitungsstrahls (L) sowie der Registriereinheit (12) gegenüber dem auf der Bearbeitungstrommel (2) befindlichen Endlossubstrat (3) einstellbar sind.

10. Vorrichtung nach Anspruch 9, **dadurch gekennzeichnet, dass** die Bearbeitungstrommel (2) mit dem Schlitten (25) derart verschiebbar ist, dass die Bearbeitungstrommel (2) aus der Axialebene (A) der Strahlungsquelle (11) und Registrierebene (R) der Registriereinheit (12) herausfahrbar ist, um auf dem Schlitten (25) zusätzlich angebrachte Justiermittel (23; 24) in Positionen anstelle von Mantellinien der Bearbeitungstrommel (2) in der Registrierebene (R) und der Axialebene (A) zu bringen.

11. Vorrichtung nach einem der Ansprüche 1 bis 10, **dadurch gekennzeichnet, dass** die Bearbeitungstrommel (2) in beiden Randbereichen (26) primäre Kalibriermarken (271) und sekundäre Kalibriermarken (272) aufweist, von denen mindestens die sekundären Kalibriermarken (272) transient durch den Bearbeitungsstrahl (L) erzeugbar sind und die zur Kalibrierung der räumlichen Beziehung zwischen den Koordinatensystemen von Registriereinheit (12) und Strahlungsquelle (11) vorgesehen sind.

12. Vorrichtung nach Anspruch 11, **dadurch gekennzeichnet, dass** die Randbereiche (26) der Bearbeitungstrommel (2) belegt sind
- mit einer Photochrombeschichtung, die für einen angepassten Wellenlängenbereich des Bearbeitungsstrahls (L) empfindlich ist, um die primären Kalibriermarken (271) und die sekundären Kalibriermarken (272) zu erzeugen, oder
- mit einem Stahlband (27) zur Einbringung der permanent eingebrachten primären Kalibriermarken (271), wobei das Stahlband (27) eine für einen angepassten Wellenlängenbereich des Bearbeitungsstrahls (L) empfindliche Photochrombeschichtung aufweist, um die sekundären Kalibriermarken (272) zu erzeugen.

13. Vorrichtung nach einem der Ansprüche 7 bis 12, **dadurch gekennzeichnet, dass**
- die Strahlungsquelle (11) als linienförmig gescannter Laser (14) ausgebildet ist und der Bearbeitungsstrahl (L) über die Randbereiche (26) der Bearbeitungstrommel (2) hinaus scannbar ist,
- die Registriereinheit (12) mindestens zwei Kameras (121) zur Aufnahme von Zielmarken (33) des Endlossubstrats (3) sowie von primären und sekundären Kalibriermarken (271; 272) im Randbereich (26) der Bearbeitungstrommel (2) aufweist und
- mindestens ein Photodetektor (28) in axialer Richtung neben der Bearbeitungstrommel (2) angeordnet ist, um wiederholt Intensitätsmessungen des Bearbeitungsstrahls (L) vorzunehmen.

14. Vorrichtung nach Anspruch 13, **dadurch gekennzeichnet, dass** jeder Photodetektor (28) parallel zur Drehachse (D) in Richtung der Bearbeitungstrommel (2) ausgerichtet ist und je ein Umlenkspiegel (281) zur Reflexion von neben der Bearbeitungstrommel (2) radial einfallendem Licht des Bearbeitungsstrahls (L) zwischen Bearbeitungstrommel (2) und Photodetektor (28) so positioniert ist, um das radial einfallende Licht des Bearbeitungsstrahls (L) in Richtung des jeweiligen Photodetektors (28) umzulenken.

15. Vorrichtung nach einem der Ansprüche 7 bis 14, **dadurch gekennzeichnet, dass** an der Bearbeitungstrommel (2) eine Andruckwalze (21) zum Anpressen des Endlossubstrats (3) angebracht ist, wobei die Andruckwalze (21) zugleich mit einem hochauflösenden Encoder (211) ausgestattet ist, um eine real zwischen Registriereinheit (12) und Bearbeitungsstrahl (L) transportierte Länge der Substratoberfläche des Endlossubstrats (3) zu messen.

16. Vorrichtung nach einem der Ansprüche 7 bis 14, **dadurch gekennzeichnet, dass** an der Bearbeitungstrommel (2) eine Andruckwalze (21) zum Anpressen des Endlossubstrats (3) in einem Bereich vor der Axialebene (A) des Bearbeitungsstrahls (L) angebracht ist, wobei die Andruckwalze (21) zugleich mit einer Cleaner-Rolle (51) in Kontakt steht, um das Endlossubstrat (3) vor der Strahlbearbeitung zu reinigen.

## Claims

1. A device for introducing a pattern by radiation on a wound endless substrate (3), in which the endless substrate (3) is guided in a rollable manner from an unwinder roll (41) over a processing drum (2) onto a winder roll (44), a registration unit (12) for optically recording target marks (33) and a radiation source (11) for irradiating a radiation pattern being directed onto the processing drum (2) in two different directions, and a control unit (13) being present for controlling the alignment between the radiation pattern and the endless substrate (3) and for locally differentiating the radiation pattern, and means being present in the control unit (13) for electronically adapting the radiation pattern to positional deviations of the endless substrate (3) determined by the registration unit (12) on the basis of the target marks (33), wherein
- a respective dancer roll (43) for the guidance under tension of the endless substrate (3) along a defined contact region (36) of at least half the circumference of the processing drum (2) is provided between the processing drum (2) and unwinder roll (41) and the processing drum (2) and winder roll (44) in order to transmit a conveying movement from the processing drum (2) via the defined contact region (36) to the endless substrate (3) in a slip-free fashion by means of a drive (22) of the processing drum (2),
- the dancer rolls (43) for the guidance under tension of substrate webs (31; 32) of the endless substrate (3) running forwards and backwards are configured with a constant force effect as a counter move to the contact region (36) on the processing drum (2),
**characterized in that** stabilizing means (45, 46) for establishing an equilibrium between a defined counterforce and the constant force effect on the dancer roll (43) are present and are linked to a measuring unit (471; 474; 475; 476) for recording changes in the deflection of the respective dancer roll (43),
and
- the unwinder roll (41) and the winder roll (44) have controllable drives (7) whose rotational speed is controlled on the basis of disturbances of the force equilibrium at the dancer roll (43) detected by the measuring unit (471; 474; 475; 476).

2. The device according to claim 1, **characterized in that** the stabilizing means comprise a lever means (45) to which said dancer roll (43) is hinged for performing a pivoting movement and include a pneumatically or hydraulically pressure controlled cylinder (46) hinged to said lever means (45) for maintaining the equilibrium between the defined counterforce and the constant force effect on the dancer roll (43), said lever means (45) allowing deflection of the dancer roll (43) along an arc of a circle.

3. The device according to claim 2, **characterized in that** the measuring unit for recording changes in the deflection of the dancer roll (43) is provided as one of the following measuring elements:
- an incremental angle encoder (471) for measuring angular changes in a pivot axis (451) of the lever means (45),
- an optical angle encoder such that, by means of a light beam which is directed, via a deflection mirror on a lever arm (452) of the lever means (45), onto a line sensor (476), angular changes of the lever means (45) can be detected as spatial changes of the light beam at the line sensor (476),
- an incremental displacement sensor (475) for measuring linear length changes of the push rod of the pressure-controlled cylinder (46), and
- a strain gauge (474) for measuring the deflection at a lever arm (452) of the lever means (45).

4. The device according to any one of claims 1 to 3, **characterized in that** the stabilizing means (45, 46) are coupled to a regulator (47) having a control loop (473) between the measuring unit (471; 474; 475; 476) and a rotational speed controller (472) of the unwinder roll (41) or the winder roll (44).

5. The device according to any one of claims 1 to 4, **characterized in that** deflection rolls (42) are provided in a substrate guide unit (4) in addition to the dancer rolls (43), which deflection rolls (42) are provided for changing the unwinding or winding direction of the unwinder roll (41) or the winder roll (44) as desired.

6. The device according to any one of claims 1 to 5, **characterized in that** deflection rolls (42) are provided in a substrate guide unit (4) in addition to the dancer rolls (43), which deflection rolls (42) are provided for guiding the endless substrate (3) in such a way that the substrate web (31) running towards the processing drum (2) and the returning substrate web (32) are guided from and to unwinder and winder rolls (41, 44) arranged spatially one above the other.

7. The device according to any one of claims 1 to 6, **characterized in that**, in a beam processing device (1), the radiation source (11) with a line-shaped processing beam (L) and the registration unit (12) with a strip-shaped scanning area are arranged parallel to an axis of rotation (D) of the processing drum (2) and are directed onto one generating line each of the processing drum (2) in different axial planes (A), or are directed in one and the same axial plane (A) onto diametrically opposite sides of the processing drum (2).

8. The device according to any one of claims 1 to 6, **characterized in that** in a beam processing device (1) the radiation source (11) with a line-shaped processing beam (L) parallel to an axis of rotation (D) and in an axial plane (A) of the processing drum (2) and the registration unit (12) with a strip-shaped scanning area in a registration plane (R) parallel to the axial plane (A) are directed onto opposite sides of the processing drum (2), wherein the registration plane (R) is positioned far enough in front of the advancing substrate web (31) that an air gap (34) is present for irradiation of backlighting (122) before a beginning (35) of the contact region (36) of the endless substrate (3) with the processing drum (2).

9. The device according to any one of claims 1 to 8, **characterized in that** the processing drum (2) is mounted on a movable carriage (25) in such a way that a linear processing beam (L) of the radiation source (11) and a strip-shaped scanning area of the registration unit (12) are displaceable by the movement of the carriage (25) tangentially to a respective more distant generating line of the processing drum (2), whereby the focusing of the processing beam (L) and of the registration unit (12) can be adjusted relative to the endless substrate (3) located on the processing drum (2).

10. The device according to claim 9, **characterized in that** the processing drum (2) is displaceable with the carriage (25) in such a way that the processing drum (2) can be moved out of the axial plane (A) of the radiation source (11) and registration plane (R) of the registration unit (12) in order to bring adjustment means (23; 24) additionally mounted on the carriage (25) into positions instead of generating lines of the processing drum (2) in the registration plane (R) and the axial plane (A).

11. The device according to any one of claims 1 to 10, **characterized in that** the processing drum (2) has, in both edge regions (26), primary calibration marks (271) and secondary calibration marks (272), of which at least the secondary calibration marks (272) can be generated transiently by the processing beam (L) and which are provided for calibrating the spatial relationship between the coordinate systems of the registration unit (12) and radiation source (11).

12. The device according to claim 11, **characterized in that** the edge regions (26) of the processing drum (2) are covered with
- a photochromic coating sensitive to an adapted wavelength range of the processing beam (L) to produce the primary calibration marks (271) and the secondary calibration marks (272), or
- a steel band (27) for introducing the permanently introduced primary calibration marks (271), the steel band (27) having a photochromic coating sensitive to an adapted wavelength range of the processing beam (L) to produce the secondary calibration marks (272).

13. The device according to any one of claims 7 to 12, **characterized in that**
- the radiation source (11) is designed as a line-scanned laser (14) and the processing beam (L) can be scanned beyond the edge regions (26) of the processing drum (2),
- the registration unit (12) has at least two cameras (121) for recording target marks (33) of the endless substrate (3) as well as primary and secondary calibration marks (271; 272) in the edge region (26) of the processing drum (2), and
- at least one photodetector (28) is arranged in an axial direction adjacent to the processing drum (2) for repeatedly taking intensity measurements of the processing beam (L).

14. The device according to claim 13, **characterized in that** each photodetector (28) is aligned parallel to the axis of rotation (D) in the direction of the processing drum (2), and a respective deflection mirror (281) for reflecting light of the processing beam (L) radially incident next to the processing drum (2) is positioned between the processing drum (2) and the photodetector (28) in such a way as to deflect the radially incident light of the processing beam (L) in the direction of the respective photodetector (28).

15. The device according to any one of claims 7 to 14, **characterized in that** a pressure roller (21) for pressing the endless substrate (3) is mounted on the processing drum (2), the pressure roller (21) being at the same time equipped with a high-resolution encoder (211) for measuring a length of the substrate surface of the endless substrate (3) actually transported between the registration unit (12) and the processing beam (L).

16. The device according to any one of claims 7 to 14, **characterized in that** a pressure roller (21) for pressing the endless substrate (3) is mounted on the processing drum (2) in a region ahead of the axial plane (A) of the processing beam (L), the pressure roller (21) being at the same time in contact with a cleaner roll (51) in order to clean the endless substrate (3) before beam processing.

## Revendications

1. Dispositif pour réaliser un motif par rayonnement sur un substrat sans fin (3) enroulé, dans lequel le substrat sans fin (3) est guidé de manière à pouvoir rouler d'un rouleau de déroulement (41) sur un rouleau d'enroulement (44) en passant par un tambour de traitement (2), une unité d'enregistrement (12) pour l'enregistrement optique de repères de visée (33) et une source de rayonnement (11) pour l'irradiation d'un motif de rayonnement étant dirigées dans deux directions différentes sur le tambour de traitement (2), et une unité de commande (13) étant présente pour la commande de l'alignement entre le motif de rayonnement et le substrat sans fin (3) et pour la différenciation locale du motif de rayonnement, des moyens étant prévus dans l'unité de commande (13) pour l'adaptation électronique du motif de rayonnement à des écarts de position du substrat sans fin (3) déterminés par l'unité d'enregistrement (12) sur la base des repères de visée (33), dans lequel
- entre le tambour de traitement (2) et le rouleau de déroulement (41) et entre le tambour de traitement (2) et le rouleau d'enroulement (44), il existe respectivement un rouleau danseur (43) pour le guidage tendu du substrat sans fin (3) le long d'une zone de contact définie (36) d'au moins une demi-circonférence du tambour de traitement (2), pour transmettre, au moyen d'un entraînement (22) du tambour de traitement (2), un mouvement de transport du tambour de traitement (2), par l'intermédiaire de la zone de contact définie (36), sans glissement sur le substrat sans fin (3),
- les rouleaux danseurs (43) sont adaptés pour un guidage tendu d'une bande de substrat aller et d'une bande de substrat retour (31 ; 32) du substrat sans fin (3) avec un effet de force constant à l'encontre de la zone de contact (36) sur le tambour de traitement (2),
**caractérisé en ce que** des dispositifs de stabilisation (45, 46) sont présents pour le réglage d'un équilibre entre une force antagoniste définie et l'effet de force constant sur le rouleau danseur (43) et sont reliés à une unité de mesure (471 ; 474 ; 475 ; 476) pour l'enregistrement des variations de la déviation du rouleau danseur (43) respectif,
et
- le rouleau de déroulement (41) et le rouleau d'enroulement (44) présentent des entraînements réglables (7) dont la vitesse de rotation est réglée sur la base de perturbations de l'équilibre des forces sur le rouleau danseur (43) détectées par l'unité de mesure (471 ; 474 ; 475 ; 476).

2. Dispositif selon la revendication 1, **caractérisé en ce que** le dispositif de stabilisation comprend un dispositif de levier (45) sur lequel le rouleau danseur (43) est articulé pour effectuer un mouvement de pivotement, et comprend un vérin (46) commandé par pression pneumatique ou hydraulique, qui est articulé sur le dispositif de levier (45) pour maintenir l'équilibre entre la force antagoniste définie et l'effet de force constant sur le rouleau danseur (43), le dispositif de levier (45) permettant une déviation du rouleau danseur (43) le long d'un arc de cercle.

3. Dispositif selon la revendication 2, **caractérisé en ce que** l'unité de mesure destinée à enregistrer les variations de la déviation du rouleau danseur (43) est conçue comme l'un des éléments de mesure suivants :
- en tant que capteur angulaire incrémental (471) pour la mesure de variations angulaires dans un axe de pivotement (451) du dispositif de levier (45),
- en tant que capteur d'angle optique, de telle sorte qu'au moyen d'un faisceau lumineux qui est dirigé sur un capteur de lignes (476) par l'intermédiaire d'un miroir de renvoi sur un bras de levier (452) du dispositif de levier (45), des variations angulaires du dispositif de levier (45) peuvent être détectées en tant que variations de position du faisceau lumineux sur le capteur de lignes (476),
- en tant que capteur de déplacement incrémental (475) pour la mesure de modifications linéaires de la longueur de la tige de poussée du vérin commandé par pression (46), et
- en tant que jauge de contrainte (474) pour mesurer la flexion sur un bras de levier (452) du dispositif de levier (45).

4. Dispositif selon l'une quelconque des revendications 1 à 3, **caractérisé en ce que** les dispositifs de stabilisation (45, 46) sont couplés à une unité de régulation (47) comportant une boucle de régulation (473) entre l'unité de mesure (471 ; 474 ; 475 ; 476) et un régulateur de vitesse de rotation (472) du rouleau de déroulement (41) ou du rouleau d'enroulement (44).

5. Dispositif selon l'une quelconque des revendications 1 à 4, **caractérisé en ce que** dans une unité de guidage de substrat (4), outre les rouleaux danseurs (43), il y a des rouleaux de renvoi (42) qui sont prévus pour modifier à volonté le sens de déroulement ou d'enroulement du rouleau de déroulement (41) ou du rouleau d'enroulement (44).

6. Dispositif selon l'une quelconque des revendications 1 à 5, **caractérisé en ce que** dans une unité de guidage de substrat (4), outre les rouleaux danseurs (43), il y a des rouleaux de renvoi (42) qui sont prévus pour le guidage du substrat sans fin (3) de telle sorte que la bande de substrat (31) allant vers le tambour de traitement (2) et la bande de substrat (32) revenant sont guidées à partir et vers des rouleaux de déroulement et d'enroulement (41, 44) disposés spatialement les uns au-dessus des autres.

7. Dispositif selon l'une quelconque des revendications 1 à 6, **caractérisé en ce que**, dans un dispositif de traitement par faisceau (1), la source de rayonnement (11) avec un faisceau de traitement (L) en forme de ligne et l'unité d'enregistrement (12) avec une zone de balayage en forme de bande sont disposées parallèlement à un axe de rotation (D) du tambour de traitement (2) et sont dirigées dans des plans axiaux différents, chacune sur une génératrice du tambour de traitement (2) ou dans un seul et même plan axial (A) sur des côtés diamétralement opposés du tambour de traitement (2).

8. Dispositif selon l'une quelconque des revendications 1 à 6, **caractérisé en ce que**, dans un dispositif de traitement par faisceau (1), la source de rayonnement (11) avec un faisceau de traitement (L) en forme de ligne est dirigée parallèlement à un axe de rotation (D) et dans un plan axial (A) du tambour de traitement (2), et l'unité d'enregistrement (12) avec une zone de balayage en forme de bande est dirigée dans un plan d'enregistrement (R) parallèle au plan axial (A) sur des côtés opposés du tambour de traitement (2), le plan d'enregistrement (R) étant avancé à l'encontre de la bande de substrat (31) s'étendant vers l'avant, de telle sorte qu'il existe un entrefer (34) pour l'irradiation d'un éclairage de face arrière (122) avant un début (35) de la zone de contact (36) du substrat sans fin (3) avec le tambour de traitement (2).

9. Dispositif selon l'une quelconque des revendications 1 à 8, **caractérisé en ce que** le tambour de traitement (2) est monté sur un chariot mobile (25) de telle sorte qu'un faisceau de traitement linéaire (L) de la source de rayonnement (11) et une zone de balayage en forme de bande de l'unité d'enregistrement (12) peuvent être déplacés tangentiellement sur une génératrice respective plus éloignée du tambour de traitement (2) par le mouvement du chariot (25), ce qui permet de régler les focalisations du faisceau de traitement (L) ainsi que de l'unité d'enregistrement (12) par rapport au substrat sans fin (3) se trouvant sur le tambour de traitement (2).

10. Dispositif selon la revendication 9, **caractérisé en ce que** le tambour de traitement (2) peut être déplacé avec le chariot (25) de telle sorte que le tambour de traitement (2) peut être sorti du plan axial (A) de la source de rayonnement (11) et du plan d'enregistrement (R) de l'unité d'enregistrement (12), afin d'amener des moyens d'ajustement (23 ; 24) montés en supplément sur le chariot (25) dans des positions à la place de génératrices du tambour de traitement (2) dans le plan d'enregistrement (R) et le plan axial (A).

11. Dispositif selon l'une quelconque des revendications 1 à 10, **caractérisé en ce que** le tambour de traitement (2) présente dans les deux zones de bord (26) des repères de calibrage primaires (271) et des repères de calibrage secondaires (272), dont au moins les repères de calibrage secondaires (272) peuvent être générés de manière transitoire par le faisceau de traitement (L) et qui sont prévus pour calibrer la relation spatiale entre les systèmes de coordonnées de l'unité d'enregistrement (12) et de la source de rayonnement (11).

12. Dispositif selon la revendication 11, **caractérisé en ce que** les zones de bord (26) du tambour de traitement (2) sont couvertes
- d'un revêtement photochromique sensible à une gamme de longueurs d'onde adaptée du faisceau de traitement (L) pour produire les repères de calibrage primaires (271) et les repères de calibrage secondaires (272), ou
- d'une bande d'acier (27) pour l'introduction des repères de calibrage primaires (271) introduites de manière permanente, la bande d'acier (27) présentant un revêtement photochromique sensible à une plage de longueurs d'onde adaptée du faisceau de traitement (L), pour produire les repères de calibrage secondaires (272).

13. Dispositif selon l'une quelconque des revendications 7 à 12, **caractérisé en ce que**
- la source de rayonnement (11) est conçue comme un laser (14) à balayage linéaire et le faisceau de traitement (L) peut être balayé au-delà des zones de bord (26) du tambour de traitement (2),
- l'unité d'enregistrement (12) présente au moins deux caméras (121) pour enregistrer des repères de visée (33) du substrat sans fin (3) ainsi que des repères de calibrage primaires et secondaires (271 ; 272) dans la zone de bord (26) du tambour de traitement (2) et
- au moins un photodétecteur (28) est disposé dans la direction axiale à côté du tambour de traitement (2) pour effectuer de manière répétée des mesures d'intensité du faisceau de traitement (L).

14. Dispositif selon la revendication 13, **caractérisé en ce que** chaque photodétecteur (28) est orienté parallèlement à l'axe de rotation (D) en direction du tambour de traitement (2) et un miroir de déviation respectif (281) pour la réflexion de la lumière du faisceau de traitement (L) tombant radialement à côté du tambour de traitement (2) est positionné entre le tambour de traitement (2) et le photodétecteur (28) de manière à dévier la lumière du faisceau de traitement (L) tombant radialement en direction du photodétecteur respectif (28).

15. Dispositif selon l'une quelconque des revendications 7 à 14, **caractérisé en ce qu'**un rouleau de pression (21) est monté sur le tambour de traitement (2) pour presser le substrat sans fin (3), le rouleau de pression (21) étant simultanément équipé d'un codeur haute résolution (211) pour mesurer une longueur réelle de la surface du substrat sans fin (3) transportée entre l'unité d'enregistrement (12) et le faisceau de traitement (L).

16. Dispositif selon l'une quelconque des revendications 7 à 14, **caractérisé en ce qu'**un rouleau de pression (21) est monté sur le tambour de traitement (2) pour presser le substrat sans fin (3) dans une zone située en avant du plan axial (A) du faisceau de traitement (L), le rouleau de pression (21) étant simultanément en contact avec un rouleau de nettoyage (51) pour nettoyer le substrat sans fin (3) avant le traitement par faisceau.
